# EUROPEAN PATENT APPLICATION

(11) **EP 4 827 310 A1**
(43) Date of publication of application: **21.10.2026**
(21) Application number: 26171860.5
(22) Date of filing: 13.04.2026
(51) Int. Cl.: H10W 20/00, H10W 20/20, H10W 72/90

(54) **SEMICONDUCTOR CHIP INCLUDING THROUGH VIA**

(30) Priority: 16.04.2025 KR 20250049697
(71) Applicant: Samsung Electronics Co., Ltd., Suwon-si, Gyeonggi-do 16677 (KR)
(72) Inventor: YANG, Hyun, 16677 Suwon-si (KR); PARK, Jongho, 16677 Suwon-si (KR); PARK, Chanwook, 16677 Suwon-si (KR); JUNG, Jaemok, 16677 Suwon-si (KR); HA, Taeoh, 16677 Suwon-si (KR)
(74) Representative: Marks & Clerk LLP

(57) **Abstract**

A semiconductor chip may include: a chip substrate including a first surface and a second surface opposite to the first surface; a passivation layer on the second surface of the chip substrate; a through via penetrating the chip substrate and the passivation layer; a chip pad on the through via and the passivation layer; and a seed layer between the through via and the chip pad and between the passivation layer and the chip pad. The passivation layer may include an etching region in which the through via is located, and an upper surface of the etching region of the passivation layer may be recessed.

## Description

### BACKGROUND

### 1. Field

Some embodiments of the present disclosure relate to a semiconductor chip, and more particularly, to a semiconductor chip including a through via.

### 2. Description of Background Art

Recently, demands for miniaturization, high integration, and high performance of electronic devices have increased, and thus three-dimensional (3D) stack technology for vertically stacking a plurality of semiconductor chips within a single package has attracted attention in the semiconductor industry. Through Silicon Via (TSV) technology may be used to electrically connect semiconductor chips of each layer in a 3D stack semiconductor structure. The size of semiconductor chips is continuously miniaturized, which decreases the size of a TSV, and as a result, an aspect ratio of TSV is gradually increasing. The defect rate of a TSV having a large aspect ratio increases during a formation process. Defects in the TSV formation process are directly linked to performance degradation and reliability problems of semiconductor devices, and thus research has been continuously conducted to improve the quality of a TSV and increase manufacturing yield.

### SUMMARY

According to some embodiments of the present disclosure, a semiconductor chip including a through via having a high aspect ratio may be provided. According to some embodiments of the present disclosure, a semiconductor chip which is more robust than and/or has improved electrical characteristics compared to conventional semiconductor chips may be provided. The semiconductor chip may be formed using etching rather than chemical mechanical polishing (CMP) and as such, bending or breaking of a through via of the semiconductor chip may be reduced or avoided. An etching region of the passivation layer may form a mask for such etching.

However, the problems to be solved by embodiments of the present disclosure are not limited to the above-mentioned problems, and other problems not mentioned that are solved by embodiments of the present disclosure may be clearly understood by one of ordinary in the art from the following description.

According to some embodiments of the present disclosure, a semiconductor chip may include: a chip substrate including a first surface and a second surface opposite to the first surface; a passivation layer on the second surface of the chip substrate; a through via penetrating the chip substrate and the passivation layer; a chip pad on the through via and the passivation layer; and a seed layer between the through via and the chip pad and between the passivation layer and the chip pad. The passivation layer may include an etching region in which the through via is located, and an upper surface of the etching region of the passivation layer may be recessed. The second surface may be opposite the first surface in the vertical direction (e.g., Z direction). The passivation layer may be on the second surface of the chip substrate in the vertical direction (e.g., Z direction). The passivation layer may overlap or overlay the chip substrate. The chip pad may be on the through via and the passivation layer in the vertical direction (e.g., Z direction). The chip pad may overlap or overlay the through via and the passivation layer. The chip pad may fully overlap or overlay the through via. The chip pad may only partially overlap or overlay the passivation layer. The upper surface of the etching region of the passivation layer may be recessed in the vertical direction (e.g., Z direction).

According to some embodiments of the present disclosure, a semiconductor chip may include: a chip substrate including a first surface and a second surface opposite to the first surface; a wiring structure on the first surface of the chip substrate, the wiring structure including a wiring pattern and a wiring insulating layer at least partially surrounding the wiring pattern; a passivation layer on the second surface of the chip substrate; a through via penetrating the chip substrate and the passivation layer; a chip pad on the through via and the passivation layer; and a seed layer between the through via and the chip pad and between the passivation layer and the chip pad. The through via may include a chamfer extending along an edge of an upper surface of the through via.

According to some embodiments of the present disclosure, a semiconductor chip may include: a chip substrate including a first surface and a second surface opposite to the first surface; a passivation layer on the second surface of the chip substrate; a through via penetrating the chip substrate and the passivation layer; a chip pad on the through via and the passivation layer; and a seed layer between the through via and the chip pad and between the passivation layer and the chip pad. The passivation layer may include an etching region in which the through via is located, and a non-etching region defining the etching region. An upper surface of the etching region of the passivation layer may be recessed. An edge of the upper surface of the etching region of the passivation layer may be curved. The through via may extend along a side surface of the etching region and include a chamfer, the chamfer including a curved surface.

At least some of the above and other features of the disclosure are set out in the claims.

### BRIEF DESCRIPTION OF DRAWINGS

Embodiments will be more clearly understood from the following detailed description taken in conjunction with the accompanying drawings in which:
FIG. 1 is a planar view schematically illustrating a semiconductor chip according to embodiments;
FIG. 2 is a planar view schematically illustrating a semiconductor chip according to embodiments;
FIG. 3 is a planar view schematically illustrating a semiconductor chip according to embodiments;
FIG. 4 is a cross-sectional view schematically illustrating a semiconductor chip according to embodiments;
FIG. 5 is an enlarged cross-sectional view schematically illustrating a part of a semiconductor chip according to embodiments;
FIG. 6 is an enlarged cross-sectional view schematically illustrating a part of a semiconductor chip according to embodiments;
FIG. 7 is an enlarged cross-sectional view schematically illustrating a part of a semiconductor chip according to embodiments;
FIG. 8 is an enlarged cross-sectional view schematically illustrating a part of a semiconductor chip according to embodiments;
FIG. 9 is an enlarged cross-sectional view schematically illustrating a part of a semiconductor chip according to embodiments;
FIG. 10 is an enlarged cross-sectional view schematically illustrating a part of a semiconductor chip according to embodiments;
FIG. 11 is an enlarged cross-sectional view schematically illustrating a part of a semiconductor chip according to embodiments;
FIG. 12 is an enlarged cross-sectional view schematically illustrating a part of a semiconductor chip according to embodiments;
FIGS. 13A to 13K are cross-sectional views illustrating a method of manufacturing a semiconductor chip in a process order, according to embodiments; and
FIGS. 14A to 14O are cross-sectional views illustrating a method of manufacturing a semiconductor chip in a process order, according to embodiments.

### DETAILED DESCRIPTION

Non-limiting example embodiments of the present disclosure are described more fully with reference to the accompanying drawings, in which example embodiments are shown. The following example embodiments may, however, be embodied in many different forms and should not be construed as limited to the example embodiments set forth herein. Rather, these embodiments are provided so that the present disclosure will be thorough and complete, and will fully convey the scope of the present disclosure to one of ordinary in the art.

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present.

Herein, spatially relative terms such as "upper surface," "lower surface," "upper portion," "lower portion," "above," and "below" are used to easily explain the positional relationship of the components with respect to directions shown in the drawings. Therefore, with respect to directions different from the directions shown in the drawings, the spatially relative terms representing the positional relationship of the components may be understood differently.

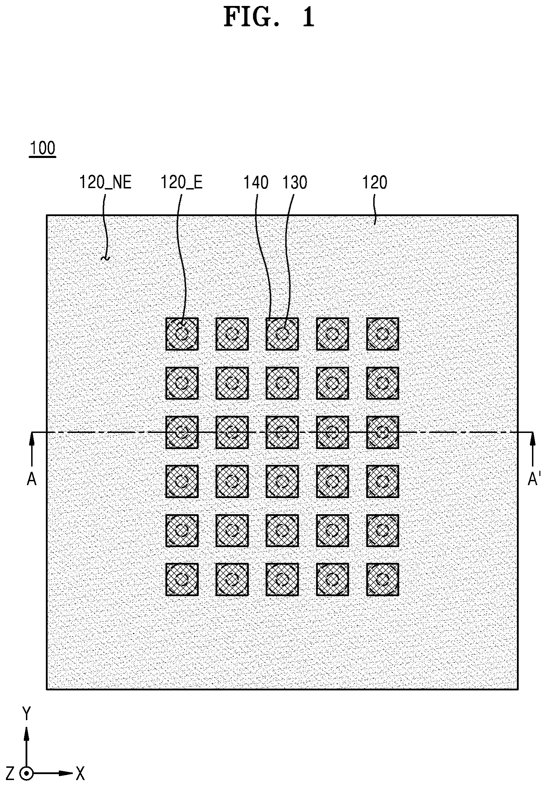

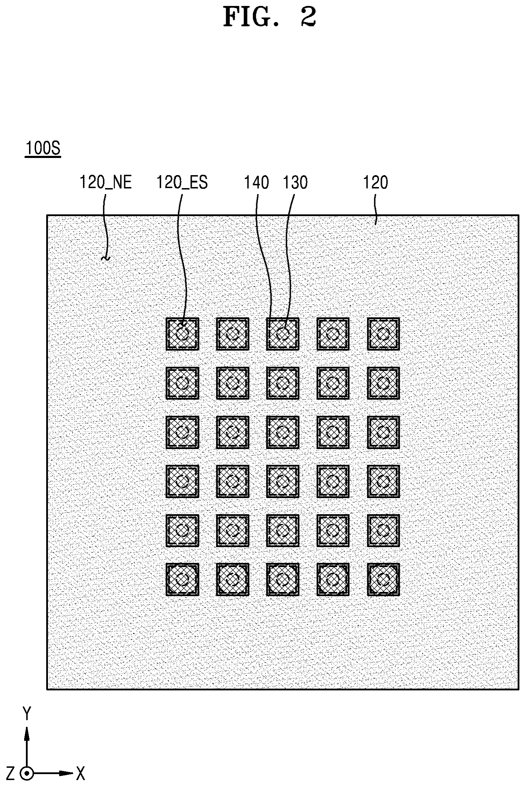

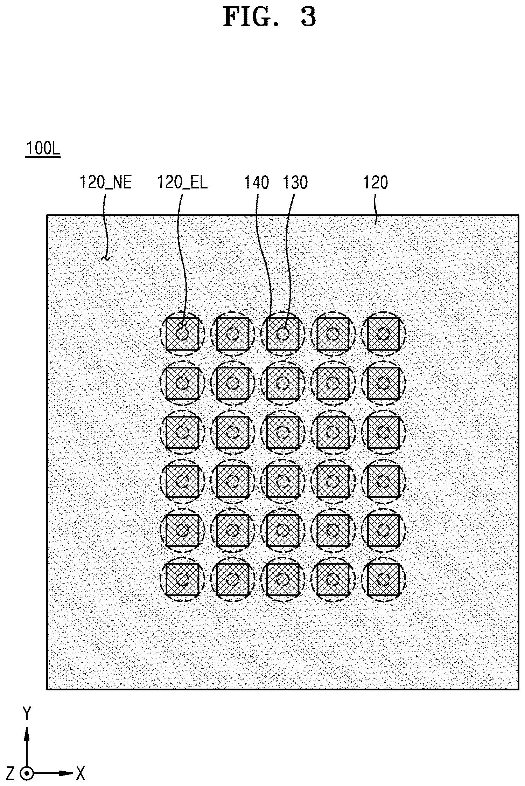

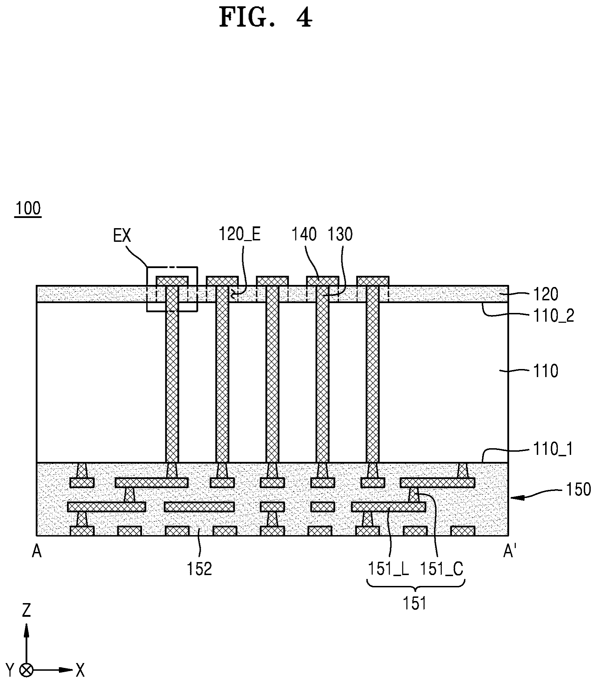

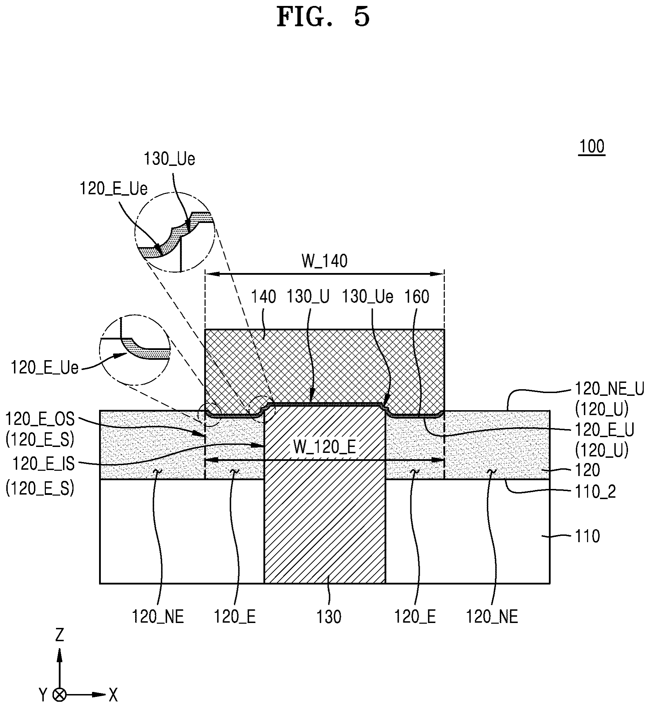

FIG. 1 is a planar view schematically illustrating a semiconductor chip 100 according to embodiments. FIG. 2 is a planar view schematically illustrating a semiconductor chip 100S according to embodiments. FIG. 3 is a planar view schematically illustrating a semiconductor chip 100L according to embodiments. FIG. 4 is a cross-sectional view schematically illustrating the semiconductor chip 100 according to embodiments. FIG. 5 is an enlarged cross-sectional view schematically illustrating a part of the semiconductor chip 100 according to embodiments.

Specifically, FIG. 4 is a cross-sectional view of the semiconductor chip 100 of FIG. 1 taken along a line A-A' of FIG. 1. FIG. 5 is an enlarged view illustrating a portion EX of FIG. 4 in the semiconductor chip 100 of FIG. 4.

An etching region 120_ES of a passivation layer 120 of the semiconductor chip 100S of FIG. 2 has a different shape from a shape of an etching region 120_E of the passivation layer 120 of the semiconductor chip 100 of FIG. 1, and an etching region 120_EL of the passivation layer 120 of the semiconductor chip 100L of FIG. 3 has a different shape from the etching region 120_L of the passivation layer 120 of the semiconductor chip 100 of FIG. 1.

First, the semiconductor chip 100 of FIG. 1 is described with reference to FIGS. 1, 4, and 5. Thereafter, the semiconductor chip 100S of FIG. 2 and the semiconductor chip 100L of FIG. 3 are described with reference to FIGS. 2 and 3.

Herein, unless specifically defined to the contrary, a direction parallel to an upper surface of a chip substrate 110 is defined as a first horizontal direction (e.g., X direction), a direction perpendicular to the upper surface of the chip substrate 110 is defined as a vertical direction (e.g., Z direction), and a direction perpendicular to the first horizontal direction (e.g., X direction) and the vertical direction (e.g., Z direction) is defined as a second horizontal direction (e.g., Y direction). A horizontal direction is defined as the first horizontal direction (e.g., Y direction), the second horizontal direction (X direction), and/or a combination thereof.

Referring to FIGS. 1, 4, and 5, the semiconductor chip 100 may include the chip substrate 110, a wiring structure 150, at least one through via 130, at least one chip pad 140, and the passivation layer 120.

The chip substrate 110 may include a first surface 110_1 and a second surface 110_2 opposite thereto. For example, a plurality of individual devices may be located on the first surface 110_1 of the chip substrate 110. For example, the first surface 110_1 of the chip substrate 110 may be referred to as a front side or an active surface, and the second surface 110_2 of the chip substrate 110 may be referred to as a back side or an inactive surface. For example, the first surface 110_1 of the chip substrate 110 may be referred to as a lower surface of the chip substrate 110, and the second surface 110_2 of the chip substrate 110 may be referred to as the upper surface of the chip substrate 110.

The chip substrate 110 may include, for example, a semiconductor material such as silicon (Si) or germanium (Ge). The chip substrate 110 may include a compound semiconductor material such as silicon carbide (SiC), gallium arsenide (GaAs), indium arsenide (InAs), and indium phosphide (InP).

In some embodiments, the chip substrate 110 may include a front end of line (FEOL) structure. The first surface 110_1 of the chip substrate 110 may be included in the FEOL structure of the chip substrate 110. For example, a plurality of individual devices and transistors may be located in the FEOL structure of the chip substrate 110.

A semiconductor device including a plurality of individual devices of various types may be formed on the first surface 110_1 of the chip substrate 110. The plurality of individual devices of the chip substrate 110 may include various microelectronic devices, for example, a metal-oxide-semiconductor field effect transistor (MOSFET) (e.g. a complementary metal-oxide-semiconductor (CMOS) transistor), an image sensor (e.g., a system large scale integration (LSI), a CMOS imaging sensor (CIS), etc.), a micro-electromechanical system (MEMS), an active device, a passive device, etc.

In some embodiments, the chip substrate 110 may include a memory cell. For example, the memory cell may be a non-volatile memory cell such as flash memory, phase-change random access memory (PRAM), magnetoresistive random access memory (MRAM), ferroelectric random access memory (FeRAM), or resistive random access memory (RRAM). In some embodiments, the memory cell may be a volatile memory cell such as dynamic random access memory (DRAM) or static random access memory (SRAM).

The wiring structure 150 may be located on the first surface 110_1 of the chip substrate 110. For example, the wiring structure 150 may be electrically connected to the FEOL structure of the chip substrate 110. For example, the wiring structure 150 may be referred to as a back end of line (BEOL) structure.

For example, the wiring structure 150 may include a first surface and a second surface opposite thereto. The first surface of the wiring structure 150 may be in contact with the first surface 110_1 of the chip substrate 110. Chip connection terminals such as solder bumps and solder balls may be attached to the second surface of the wiring structure 150. For example, the first surface of the wiring structure 150 may be referred to as an upper surface, and the second surface of the wiring structure 150 may be referred to as a lower surface.

The wiring structure 150 may include a wiring pattern 151 and a wiring insulating layer 152 surrounding the wiring pattern 151. The wiring pattern 151 may include at least one wiring line 151_L extending in a horizontal direction, and at least one wiring contact 151_C extending in a vertical direction (e.g., Z direction) from the at least one wiring line 151_L. The at least one wiring pattern 151 may be electrically connected to the plurality of individual devices located on the first surface 110_1 of the chip substrate 110. The wiring pattern 151 may include copper, nickel, stainless steel, or beryllium copper.

The passivation layer 120 may be located on the second surface 110_2 of the chip substrate 110. The passivation layer 120 may be spaced apart from the first surface 110_1 of the chip substrate 110. For example, the passivation layer 120 may be referred to as a back side protective layer.

For example, the passivation layer 120 may be located on an upper portion of the chip substrate 110, and the wiring structure 150 may be located on a lower portion of the chip substrate 110. The passivation layer 120 and the wiring structure 150 may be spaced apart from each other with the chip substrate 110 disposed therebetween.

The passivation layer 120 may include a first surface and a second surface opposite thereto. The first surface of the passivation layer 120 may be in contact with the second surface 110_2 of the chip substrate 110, and an external semiconductor chip may be attached or attachable to the second surface of the passivation layer 120. For example, the first surface of the passivation layer 120 may be referred to as a lower surface, and the second surface of the passivation layer 120 may be referred to as an upper surface.

In some embodiments, the passivation layer 120 may include an insulating material. For example, the passivation layer 120 may include at least one from among silicon oxide, silicon nitride, polyimide, and SiON. In FIG. 4, the passivation layer 120 is shown as a single layer structure, but the passivation layer 120 may have a multi-layer structure.

The through via 130 may penetrate the chip substrate 110 and the passivation layer 120. The through via 130 may extend from the first surface 110_1 of the chip substrate 110 toward the second surface of the passivation layer 120 in the vertical direction (e.g., Z direction). For example, the through via 130 may completely penetrate the chip substrate 110 and the passivation layer 120.

The through via 130 may be electrically connected to the wiring structure 150. The through via 130 may be electrically connected to the wiring pattern 151 of the wiring structure 150. In some embodiments, the through via 130 may include copper, nickel, stainless steel, or beryllium copper.

The chip pad 140 may be located on the through via 130 and the passivation layer 120. For example, the chip pad 140 may overlap with the through via 130 in the vertical direction (e.g., Z direction) or the chip pad 140 may overlay the through via 130 in the vertical direction (e.g., Z direction). The chip pad 140 may be electrically connected to the through via 130. In some embodiments, the semiconductor chip 100 may be electrically connected to an external semiconductor chip through the at least one chip pad 140 and the passivation layer 120.

In a plan view, an area of the chip pad 140 may be larger than an area of the through via 130. For example, a part of a lower surface of the chip pad 140 protruding to the outside of the through via 130 may be in contact with the passivation layer 120. In some embodiments, an upper surface of the through via 130 may have a circular shape, and an upper surface of the chip pad 140 may have a rectangular shape.

For example, the chip pad 140 may include copper, nickel, stainless steel, or beryllium copper. In some embodiments, a material forming the chip pad 140 may be the same as a material forming the through via 130.

The passivation layer 120 may include the etching region 120_E and a non-etching region 120_NE. The non-etching region 120_NE of the passivation layer 120 may define the etching region 120_E of the passivation layer 120. The etching region 120_E of the passivation layer 120 may surround the at least one through via 130. For example, a part of the at least one through via 130 may be located in the etching region 120_E of the passivation layer 120. For example, the etching region 120_E of the passivation layer 120 may include an inner surface 120_E_IS in contact with the through via 130 and an outer surface 120_E_OS in contact with the non-etching region 120_NE. The outer surface 120_E_OS of the etching region 120_E of the passivation layer 120 and the inner surface 120_E_IS of the etching region 120_E of the passivation layer 120 may be collectively referred to as a side surface 120_E_S of the etching region 120_E of the passivation layer 120.

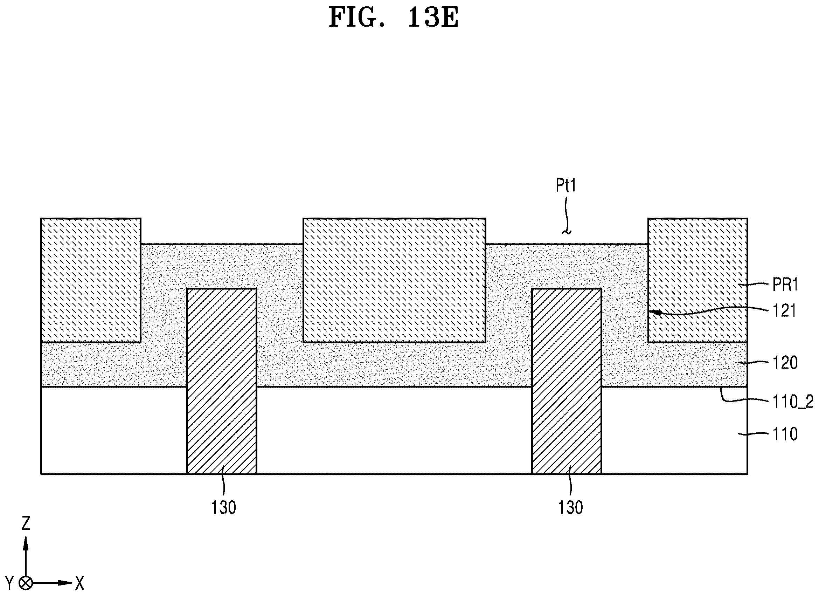

The outer surface 120_E_OS of the etching region 120_E of the passivation layer 120 may be a virtual surface distinguished from the non-etching region 120_NE of the passivation layer 120. The outer surface 120_E_OS of the etching region 120_E of the passivation layer 120 may be substantially the same as a side surface of a first opening Pt1 (see FIG. 13E) of a first mask layer PR1 (see FIG. 13E) (e.g., a side surface of the first mask layer PR1 defining the first opening Pt1) formed during an etching process of the passivation layer 120.

For example, a shape of the outer surface 120_E_OS of the passivation layer 120 may vary according to a shape of the first opening Pt1 (see FIG. 13E) of the first mask layer PR1 (see FIG. 13E). In addition, a diameter (or horizontal width) of the outer surface 120_E_OS of the passivation layer 120 may vary according to a diameter (or horizontal width) of the first opening Pt1 (see FIG. 13E) of the first mask layer PR1 (see FIG. 13E).

Referring to FIG. 1, in some embodiments, an upper surface 120_E_U (see FIG. 5) of the etching region 120_E of the passivation layer 120 may have a circular shape in a plan view. The through via 130 having the upper surface in a circular shape may be located in the etching region 120_E of the passivation layer 120. A diameter W_120_E (see FIG. 5) of the etching region 120_E of the passivation layer 120 may be greater than a diameter of the through via 130.

In some embodiments, the diameter W_120_E of the etching region 120_E of the passivation layer 120 may be the same as a horizontal width W_140 of the chip pad 140. For example, a part of the outer surface 120_E_OS of the etching region 120_E of the passivation layer 120 may be aligned (e.g., coplanar) with a side surface of the chip pad 140 in the vertical direction (e.g., Z direction), or the other part of the outer surface 120_E_OS of the etching region 120_E of the passivation layer 120 may be located on the lower surface of the chip pad 140.

In addition, in a plan view, the area of the etching region 120_E of the passivation layer 120 may be smaller than the area of the chip pad 140. For example, the etching region 120_E of the passivation layer 120 may be located on a lower portion of the chip pad 140. For example, the outer surface 120_E_OS of the passivation layer 120 may overlap with the lower surface of the chip pad 140 in the vertical direction (e.g., Z direction). In some embodiments, the diameter W_120_E of the etching region 120_E of the passivation layer 120 may be the same as the horizontal width W_140 of the chip pad 140.

Referring to FIG. 2, in some embodiments, in a plan view, an upper surface of the etching region 120_ES of the passivation layer 120 of the semiconductor chip 100S may have a rectangular shape. For example, a horizontal width of the etching region 120_ES of the passivation layer 120 may be greater than a diameter of the through via 130. For example, the through via 130 may be located in the etching region 120_ES of the passivation layer 120. However, the embodiments of the present disclosure are not limited thereto, and the etching region 120_ES of the passivation layer 120 may have various polygonal shapes.

Referring to FIG. 3, in some embodiments, in a plan view, the area of the etching region 120_EL of the passivation layer 120 of the semiconductor chip 100L may be greater than the area of the chip pad 140. The side surface of the chip pad 140 may vertically overlap with an upper surface of the etching region 120_EL of the passivation layer 120. For example, a diameter (or horizontal width) of the etching region 120_EL of the passivation layer 120 may be greater than the horizontal width W_140 of the chip pad 140.

Referring back to FIGS. 1, 4, and 5, aspects of the example embodiments are described below. In particular, the etching region 120_E of the passivation layer 120, the through via 130, and a seed layer 160 are described with reference to FIG. 5.

An upper surface 120_U of the passivation layer 120 may be at least partially curved. The upper surface 120_E_U of the etching region 120_E of the passivation layer 120 may be recessed. For example, the upper surface 120_E_U of the etching region 120_E of the passivation layer 120 may be recessed, and an upper surface 120_NE_U of the non-etching region 120_NE of the passivation layer 120 may be flat.

For example, a vertical level of the uppermost part of the upper surface 120_E_U of the etching region 120_E of the passivation layer 120 may be different from a vertical level of the lowermost part of the upper surface 120_E_U of the etching region 120_E of the passivation layer 120. For example, the lowermost part of the upper surface 120_E_U of the etching region 120_E of the passivation layer 120 may be located at a vertical level below the vertical level of the uppermost part of the upper surface 120_E_U of the etching region 120_E of the passivation layer 120. Herein, the vertical level may mean a distance from the lower surface of the chip substrate 110.

For example, the uppermost part of the upper surface 120_E_U of the etching region 120_E of the passivation layer 120 may be connected to the uppermost end of the side surface 120_E_S of the etching region 120_E of the passivation layer 120. The uppermost part of the upper surface 120_E_U of the etching region 120_E of the passivation layer 120 may be substantially the same as the uppermost end of the side surface 120_E_S of the etching region 120_E of the passivation layer 120.

In some embodiments, an edge 120_E_Ue of the upper surface 120_E_U of the etching region 120_E of the passivation layer 120 may be curved (e.g., rounded). For example, the upper surface 120_E_U of the etching region 120_E of the passivation layer 120 may include a flat first region. The first region of the upper surface 120_E_U of the etching region 120_E of the passivation layer 120 may have no curvature, and may be surrounded by the edge 120_E_Ue of the upper surface 120_E of the etching region 120_E of the passivation layer 120.

A vertical level of the first region of the upper surface 120_E_U of the etching region 120_E of the passivation layer 120 may be lower than a vertical level of the uppermost end of the side surface 120_E_S of the etching region 120_E of the passivation layer 120. The edge 120_E_Ue of the upper surface 120_E_U of the etching region 120_E of the passivation layer 120 may extend to be curved (e.g., rounded) to the uppermost end of the side surface 120_E_S of the etching region 120_E of the passivation layer 120, from the first region of the upper surface 120_E_U of the etching region 120_E of the passivation layer 120.

In some embodiments, a first edge of the upper surface 120_E_U of the etching region 120_E of the passivation layer 120 may be located between the first region of the upper surface 120_E_U of the etching region 120_E of the passivation layer 120 and the inner surface 120_E_IS of the etching region 120_E of the passivation layer 120. A second edge of the upper surface 120_E_U of the etching region 120_E of the passivation layer 120 may be located between the first region of the upper surface 120_E_U of the etching region 120_E of the passivation layer 120 and the outer surface 120_E_OS of the etching region 120_E of the passivation layer 120. For example, a curvature of the first edge and a curvature of the second edge may be different from each other.

In some embodiments, the etching region 120_E of the passivation layer 120 may be a region in which the passivation layer 120 is etched to expose the through via 130 from the passivation layer 120. For example, a process of etching the passivation layer 120 may be a dry etching process. Accordingly, the upper surface 120_E_U of the etching region 120_E of the passivation layer 120 may include the flat first region and the rounded edge 120_E_Ue. The non-etching region 120_NE may be a region in which the passivation layer 120 is not etched. The etching region 120_E may be configured or adapted to be etched. The non-etching region 120_NE is configured or adapted to not be etched, i.e., to withstand etching.

In some embodiments, the vertical level of the uppermost end of the side surface 120_E_S of the etching region 120_E of the passivation layer 120 may be the same as a vertical level of the upper surface 120_NE_U of the non-etching region 120_NE of the passivation layer 120. The vertical level of the first region of the upper surface 120_E_U of the etching region 120_E of the passivation layer 120 may be lower than the vertical level of the upper surface 120_NE_U of the non-etching region 120_NE of the passivation layer 120.

The through via 130 may further include a chamfer 130_Ue. The chamfer 130_Ue may extend along an edge of an upper surface 130_U of the through via 130. For example, the chamfer 130_Ue may extend between a side surface of the through via 130 and the upper surface 130_U of the through via 130. The chamfer 130_Ue may be formed such that a horizontal width of the through via 130 decreases toward the upper surface 130_U of the through via 130. For example, the chamfer 130_Ue may be concavely recessed inwardly of the through via 130, at an edge of the upper surface 130_U of the through via 130. For example, the chamfer 130_Ue may have a curved surface.

In some embodiments, in order to adjust the height of the through via 130, the chamfer 130_Ue of the through via 130 may be formed in a process of performing an etching process on the through via 130. For example, when the process of etching the through via 130 is performed by wet etching, the chamfer 130_Ue of the through via 130 may be a curved surface recessed inwardly of the through via 130.

In some embodiments, the lowermost end of the chamfer 130_Ue of the through via 130 may be connected to the uppermost end of the edge 120_E_Ue of the upper surface 120_E of the etching region 120_E of the passivation layer 120. For example, the lowermost end of the chamber 130_Ue of the through via 130 may be in contact with the uppermost end of the inner surface 120_E_IS of the etching region 120_E of the passivation layer 120. For example, the vertical level of the lowermost end of the chamfer 130_Ue of the through via 130 may be the same as the vertical level of the uppermost end of the inner surface 120_E_IS of the etching region 120_E of the passivation layer 120.

The seed layer 160 may be located between the chip pad 140 and the through via 130 and between the chip pad 140 and the passivation layer 120. The seed layer 160 may be located on the lower surface of the chip pad 140. The seed layer 160 may be conformally formed on the lower surface of the chip pad 140. For example, the seed layer 160 may have a curved shape.

The seed layer 160 may be located on the upper surface 120_E_U of the etching region 120_E of the passivation layer 120. For example, the seed layer 160 may be conformally formed on the upper surface 120_E_U of the etching region 120_E of the passivation layer 120. For example, a part of the seed layer 160 may have a curvature along the edge 120_E_Ue of the upper surface 120_E_U of the etching region 120_E of the passivation layer 120.

The seed layer 160 may be located on the upper surface 130_U of the through via 130 and the chamfer 130_Ue of the through via 130. For example, the seed layer 160 may be conformally formed on the upper surface 130_U of the through via 130 and the chamfer 130_Ue of the through via 130. For example, a part of the seed layer 160 may have a curvature along the curved surface of the chamfer 130_Ue of the through via 130.

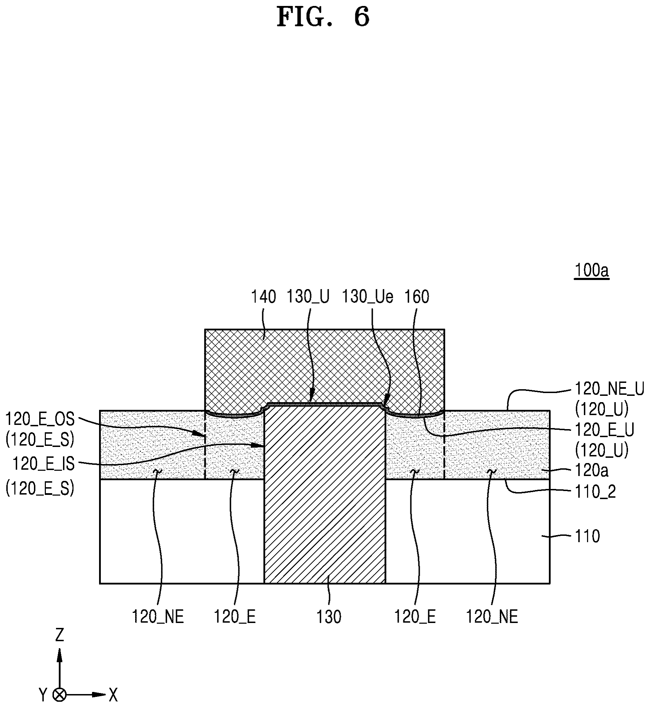

FIG. 6 is an enlarged cross-sectional view schematically illustrating a part of a semiconductor chip 100a according to embodiments. Specifically, FIG. 6 is an enlarged cross-sectional view illustrating the portion EX of FIG. 4 in the semiconductor chip 100a.

Most of the components constituting the semiconductor chip 100a described below and materials constituting the components may be substantially the same as or similar to those described with reference to FIG. 5. Therefore, for convenience of description, the differences between the semiconductor chip 100a of FIG. 6 and the semiconductor chip 100 of FIG. 5 are mainly described below.

Referring to FIG. 6, the semiconductor chip 100a may include the chip substrate 110, the wiring structure 150 (see FIG. 4), the through via 130, a passivation layer 120a, the chip pad 140, and the seed layer 160. In the semiconductor chip 100a of FIG. 6, a shape of an upper surface of the passivation layer 120a is different from a shape of an upper surface of the passivation layer 120 of the semiconductor chip 100 of FIG. 5.

The passivation layer 120a of the semiconductor chip 100a may include the etching region 120_E and the non-etching region 120_NE defining the etching region 120_E. The through via 130 may be located inside the etching region 120_E of the passivation layer 120a. For example, the through via 130 may penetrate the etching region 120_E of the passivation layer 120a in the vertical direction (Z direction).

The upper surface 120_E_U of the etching region 120_E of the passivation layer 120a, which is a part of a second surface of the passivation layer 120a, may be spaced apart from the chip substrate 110 in the vertical direction (e.g., Z direction). The inner surface 120_E_IS of the etching region 120_E of the passivation layer 120a may be in contact with a side surface of the through via 130. The outer surface 120_E_OS of the etching region 120_E of the passivation layer 120a may be in contact with the non-etching region 120_NE of the passivation layer 120a. The outer surface 120_E_OS of the etching region 120_E of the passivation layer 120a may be a virtual surface inside the passivation layer 120a.

The upper surface 120_E_U of the etching region 120_E of the passivation layer 120a may be recessed inward. For example, the upper surface 120_E_U of the etching region 120_E of the passivation layer 120a may be a concave curved surface. In some embodiments, a concave curved surface having a curvature in an upper surface 120_U of the passivation layer 120a may be the etching region 120_E of the passivation layer 120a. For example, the upper surface 120_E_U of the etching region 120_E of the passivation layer 120a may come closer to the lower surface of the passivation layer 120a in a direction away from a side surface 120_E_S of the passivation layer 120a. The upper surface 120_E_U of the etching region 120_E of the passivation layer 120a may come closer to the lower surface of the passivation layer 120a as the upper surface 120_E_U extends away from a side surface 120_E_S of the etching region 120_E of the passivation layer 120a. A lowest point of the upper surface 120_E_U of the etching region 120_E may be a point furthest from side surfaces 120_E_S of etching layer 120_E the passivation layer 120a, e.g., in a horizontal (X axis) direction.

For example, in order to expose the through via 130 buried inside the passivation layer 120a to the outside, a wet etching process may be performed in a process of etching the etching region 120_E of the passivation layer 120a. Accordingly, the upper surface 120_E_U of the etching region 120_E of the passivation layer 120a may be curved.

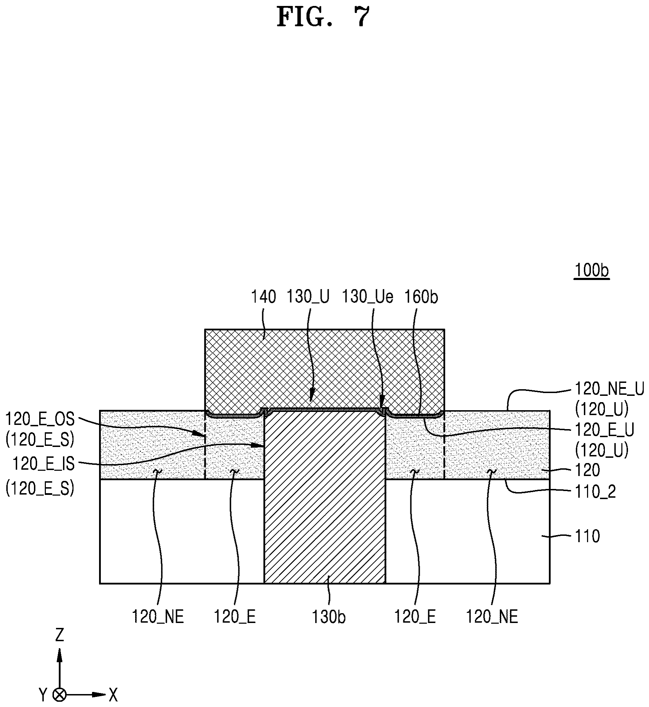

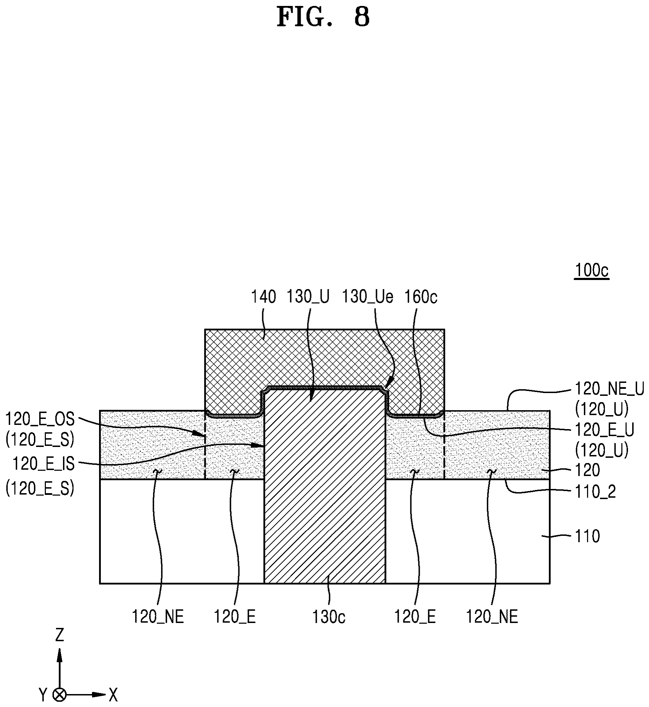

FIG. 7 is an enlarged cross-sectional view schematically illustrating a part of a semiconductor chip 100b according to embodiments. FIG. 8 is an enlarged cross-sectional view schematically illustrating a part of a semiconductor chip 100c according to embodiments. Specifically, FIGS. 7 and 8 are enlarged cross-sectional views illustrating the portion EX (see FIG. 4) of the semiconductor chips 100b and 100c, respectively.

Most of the components constituting the semiconductor chips 100b and 100c described below and materials constituting the components may be substantially the same as or similar to those described with reference to FIG. 5. Therefore, for convenience of description, the differences between the semiconductor chips 100b and 100c of FIGS. 7 and 8 and the semiconductor chip 100 of FIG. 5 are mainly described below.

Referring to FIG. 7, the semiconductor chip 100b may include the chip substrate 110, the wiring structure 150 (see FIG. 4), a through via 130b, the passivation layer 120, the chip pad 140, and a seed layer 160b. A height of the through via 130b of FIG. 7 is different from a height of the through via 130 of the semiconductor chip 100 of FIG. 5.

The through via 130b of the semiconductor chip 100b may include the chamfer 130_Ue extending along an edge of the upper surface 130_U of the through via 130b. The chamfer 130_Ue of the through via 130b may be a curved surface concavely recessed inwardly of the through via 130b. A horizontal width of the through via 130b may be narrower toward the upper surface 130_U of the through via 130b by the chamfer 130_Ue of the through via 130b. In some embodiments, the lowermost end of the chamfer 130_Ue of the through via 130b may be connected to a side surface of the through via 130b, and the uppermost end of the chamfer 130_Ue of the through via 130b may be connected to the upper surface 130_U of the through via 130b.

A vertical level of the lowermost end of the chamfer 130_Ue of the through via 130b may be lower than a vertical level of the upper surface 120_U of the passivation layer 120. For example, the vertical level of the lowermost end of the chamfer 130_Ue of the through via 130b may be lower than a vertical level of the uppermost end of the inner surface 120_E_IS of the etching region 120_E of the passivation layer 120.

The seed layer 160b may be located on the upper surface 130_U of the through via 130b and the chamfer 130_Ue of the through via 130b. The seed layer 160b may be located on the upper surface 120_E_U of the etching region 120_E of the passivation layer 120 and the inner surface 120_E_IS of the etching region 120_E of the passivation layer 120.

For example, a part of the seed layer 160b may extend from the uppermost end of the inner surface 120_E_IS of the etching region 120_E of the passivation layer 120 to the lowermost end of the chamfer 130_Ue of the through via 130b in the vertical direction (e.g., Z direction) along the inner surface 120_E_IS of the etching region 120_E of the passivation layer 120.

Referring to FIG. 8, the semiconductor chip 100c may include the chip substrate 110, the wiring structure 150 (see FIG. 4), a through via 130c, the passivation layer 120, the chip pad 140, and a seed layer 160c. A height of the through via 130b of the semiconductor chip 100c of FIG. 8 is different from the height of the through via 130 of the semiconductor chip 100 of FIG. 5.

The through via 130c of the semiconductor chip 100c may include the chamfer 130_Ue extending along an edge of the upper surface 130_U of the through via 130c. The chamfer 130_Ue of the through via 130c may be a curved surface concavely recessed inwardly of the through via 130c. In some embodiments, the lowermost end of the chamfer 130_Ue of the through via 130c may be connected to a side surface of the through via 130c, and the uppermost end of the chamfer 130_Ue of the through via 130c may be connected to the upper surface 130_U of the through via 130c.

A vertical level of the lowermost end of the chamfer 130_Ue of the through via 130c may be higher than a vertical level of the upper surface 120_U of the passivation layer 120. For example, the vertical level of the lowermost end of the chamfer 130_Ue of the through via 130c may be higher than a vertical level of the uppermost end of the inner surface 120_E_IS of the etching region 120_E of the passivation layer 120. The uppermost end of the inner surface 120_E_IS of the etching region 120_E of the passivation layer 120 may be in contact with the side surface of the through via 130c.

The seed layer 160c may be located on the upper surface 130_U of the through via 130c, the chamfer 130_Ue of the through via 130c, and the side surface of the through via 130c. The seed layer 160c may be located on the upper surface 120_E_U of the etching region 120_E of the passivation layer 120.

For example, a part of the seed layer 160c may extend from the uppermost end of the inner surface 120_E_IS of the etching region 120_E of the passivation layer 120 to the lowermost end of the chamfer 130_Ue of the through via 130c in the vertical direction (e.g., Z direction) along the side surface of the through via 130c.

In a process of forming the semiconductor chips 100b and 100c, heights of the through vias 130b and 130c may be adjusted by etching a part of the passivation layer 120 and then, performing an etching process on the through vias 130b and 130c that are exposed. Through the etching process, the vertical level of the upper surfaces 130_U of each of the through vias 130b and 130c may be independent of the vertical level of the upper surface 120_U of the passivation layer 120.

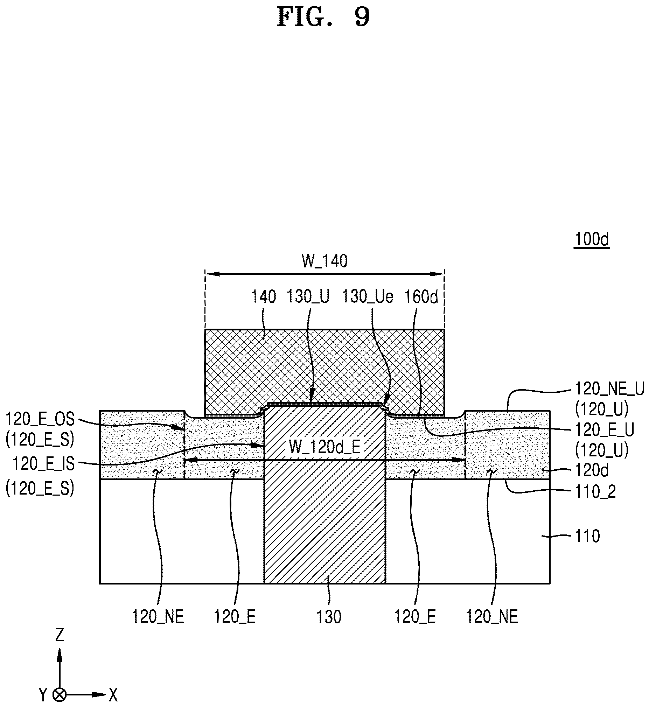

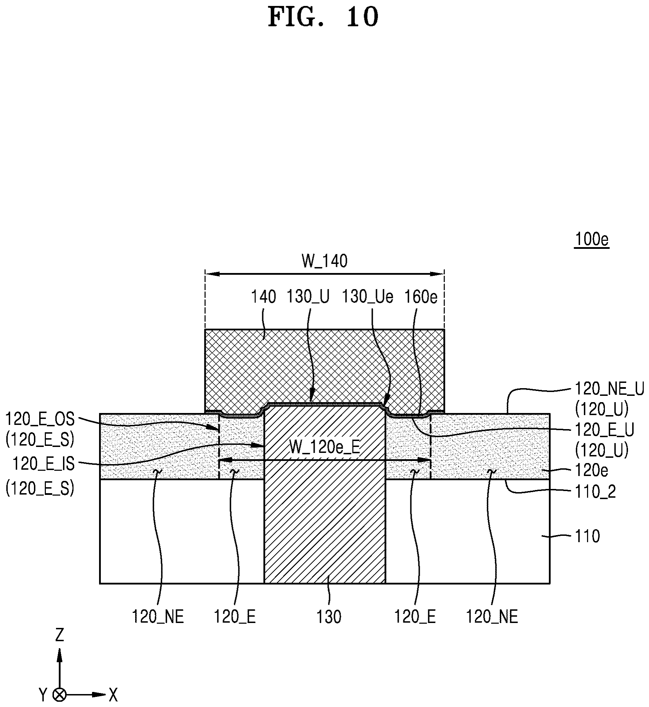

FIG. 9 is an enlarged cross-sectional view schematically illustrating a part of a semiconductor chip 100d according to embodiments. FIG. 10 is an enlarged cross-sectional view schematically illustrating a part of a semiconductor chip 100e according to embodiments. Specifically, FIGS. 9 and 10 are enlarged cross-sectional views illustrating the portion EX (see FIG. 4) of the semiconductor chips 100d and 100e, respectively.

Most of the components constituting the semiconductor chips 100d and 100e described below and materials constituting the components may be substantially the same as or similar to those described above with reference to FIG. 5. Therefore, for convenience of explanation, the differences between the semiconductor chips 100d and 100e of FIGS. 9 and 10 and the semiconductor chip 100 of FIG. 5 are mainly described below.

Referring to FIG. 9, the semiconductor chip 100d may include the chip substrate 110, the wiring structure 150 (see FIG. 4), the through via 130, a passivation layer 120d, the chip pad 140, and a seed layer 160d. In the semiconductor chip 100d of FIG. 9, the area of the etching region 120_E of the passivation layer 120d is different from the area of the etching region 120_E of the passivation layer 120 of the semiconductor chip 100 of FIG. 5.

The etching region 120_E of the passivation layer 120d of the semiconductor chip 100d may overlap with or be overlapped by the chip pad 140 in the vertical direction (e.g., Z direction). The through via 130 may be located inside the etching region 120_E of the passivation layer 120d. For example, the through via 130 may penetrate the etching region 120_E of the passivation layer 120d and be electrically connected to the chip pad 140.

The outer surface 120_E_OS of the etching region 120_E of the passivation layer 120d may be in contact with the non-etching region 120_NE of the passivation layer 120d in the side surface 120_E_S of the etching region 120_E of the passivation layer 120d. For example, in a process of etching the outer surface 120_E_OS of the etching region 120_E of the passivation layer 120d, the outer surface 120_E_OS may be aligned (e.g., coplanar) with a sidewall of the first opening Pt1 (see FIG. 13E) of the first mask layer PR1.

In a plan view, the outer surface 120_E_OS of the etching region 120_E of the passivation layer 120d may be located outside the chip pad 140 in at least one horizontal direction (e.g., X direction and/or Y direction). The side surface of the chip pad 140 may be located on a first region of the upper surface 120_E_U of the etching region 120_E of the passivation layer 120d. For example, a horizontal width W_120d_E of the etching region 120_E of the passivation layer 120d may be greater than the horizontal width W_140 of the chip pad 140. The chip pad 140 may only partially overlay or overlap (e.g., in the Z direction) the etching region 120_E of the passivation layer 120d.

The seed layer 160d may be located on the upper surface 130_U of the through via 130 and the chamfer 130_Ue of the through via 130. The seed layer 160d may be located on the upper surface 120_E_U of the etching region 120_E of the passivation layer 120d.

For example, the seed layer 160d may overlap with or overlay the inner surface 120_E_IS of the etching region 120_E of the passivation layer 120d in the vertical direction (e.g., Z direction), but may not overlap with the outer surface 120_E_OS of the etching region 120_E of the passivation layer 120d in the vertical direction (e.g., Z direction). For example, in a plan view, the outer surface 120_E_OS of the etching region 120_E of the passivation layer 120d may be spaced apart from a side surface of the seed layer 160d. The seed layer 160d may partially overlay or overlap the etching region 120_E of the passivation layer 120d.

For example, the seed layer 160d may be located on a lower surface of the chip pad 140. The side surface of the seed layer 160d may be coplanar with the side surface of the chip pad 140. For example, the side surface of the seed layer 160d may be located on the upper surface 120_E_U of the etching region 120_E of the passivation layer 120d. For example, the side surface of the seed layer 160d may be located on the first region of the upper surface 120_E_U of the etching region 120_E of the passivation layer 120d.

Referring to FIG. 10, the semiconductor chip 100e may include the chip substrate 110, the wiring structure 150 (see FIG. 4), the through via 130, a passivation layer 120e, the chip pad 140, and a seed layer 160e. In the semiconductor chip 100e of FIG. 10, the area of the etching region 120_E of the passivation layer 120e is different from the area of the etching region 120_E of the passivation layer 120 of the semiconductor chip 100 of FIG. 5.

The etching region 120_E of the passivation layer 120e of the semiconductor chip 100e may overlap with or be overlapped by the chip pad 140 in the vertical direction (e.g., Z direction). The through via 130 may be located inside the etching region 120_E of the passivation layer 120e. For example, the through via 130 may penetrate the etching region 120_E of the passivation layer 120e and be electrically connected to the chip pad 140.

The outer surface 120_E_OS of the etching region 120_E of the passivation layer 120e may be located below a lower portion of the chip pad 140. For example, in a plan view, the side surface of the chip pad 140 may be located outside the outer surface 120_E_OS of the etching region 120_E of the passivation layer 120e in at least one horizontal direction (e.g., the X direction and/or the Y direction). For example, the side surface of the chip pad 140 may be located on the non-etching region 120_NE of the passivation layer 120e. The horizontal width W_140 of the chip pad 140 may be greater than a horizontal width W_120e_E of the etching region 120_E of the passivation layer 120e. The chip pad 140 may completely overlap or overlay the etching region 120_E of the passivation layer 120e in the vertical direction (e.g., Z direction). The chip pad 140 may also partially overlap or overlay the non-etching region 120_NE of the passivation layer 120e in the vertical direction (e.g., Z direction).

The seed layer 160e may be located on the upper surface 130_U of the through via 130 and the chamfer 130_Ue of the through via 130. The seed layer 160e may be located on the upper surface 120_E_U of the etching region 120_E of the passivation layer 120e and the upper surface 120_NE_U of the non-etching region 120_NE of the passivation layer 120e. For example, the seed layer 160e may extend beyond the etching region 120_E of the passivation layer 120e to the non-etching region 120_NE of the passivation layer 120e. For example, the side surface of the seed layer 160e may be coplanar with the side surface of the chip pad 140. For example, the seed layer 160e may have a curved shape. The seed layer 160e may completely overlap or overlay the etching region 120_E of the passivation layer 120e in the vertical direction (e.g., Z direction). The seed layer 160e may also partially overlap or overlay the non-etching region 120_NE of the passivation layer 120e in the vertical direction (e.g., Z direction).

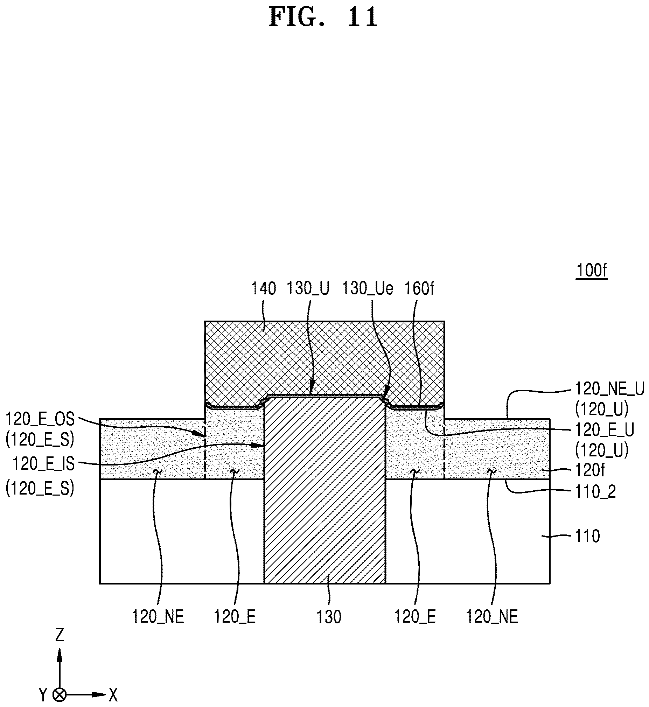

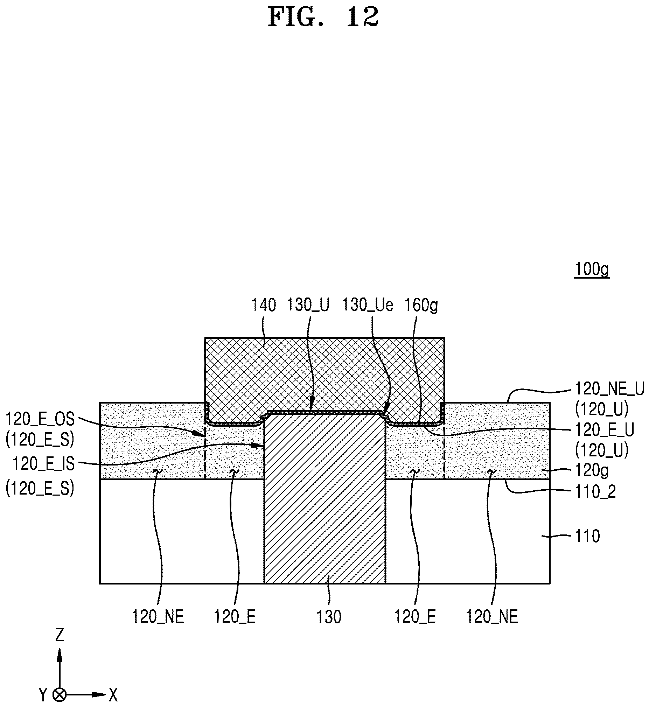

FIG. 11 is an enlarged cross-sectional view schematically illustrating a part of a semiconductor chip 100f according to embodiments. FIG. 12 is an enlarged cross-sectional view schematically illustrating a part of a semiconductor chip 100g according to embodiments. Specifically, FIGS. 11 and 12 are enlarged cross-sectional views illustrating the portion EX (see FIG. 4) of the semiconductor chips 100f and 100g, respectively.

Most of the components constituting the semiconductor chips 100f and 100g described below and materials constituting the components may be substantially the same as or similar to those described above with reference to FIG. 5. Therefore, for convenience of description, the differences between the semiconductor chips 100f and 100g of FIGS. 11 and 12 and the semiconductor chip 100 of FIG. 5 are mainly described below.

Referring to FIG. 11, the semiconductor chip 100f may include the chip substrate 110, the wiring structure 150 (see FIG. 4), the through via 130, a passivation layer 120f, the chip pad 140, and a seed layer 160f. A thickness of the passivation layer 120f in the etching region 120_E of the passivation layer 120f of the semiconductor chip 100f of FIG. 11 is different from a thickness of the passivation layer 120 in the etching region 120_E of the passivation layer 120 of the semiconductor chip 100 of FIG. 5. A height (e.g., in vertical direction (Z direction)) of the passivation layer 120f in the etching region 120_E of the passivation layer 120f of the semiconductor chip 100f of FIG. 11 is different from a thickness of the passivation layer 120 in the etching region 120_E of the passivation layer 120 of the semiconductor chip 100 of FIG. 5.

The passivation layer 120f of the semiconductor chip 100f may include the etching region 120_E and the non-etching region 120_NE defining the etching region 120_E. The thickness of the passivation layer 120f in the etching region 120_E of the passivation layer 120f may be different from the thickness of the passivation layer 120f in the non-etching region 120_NE of the passivation layer 120f. For example, a step may be formed between the etching region 120_E of the passivation layer 120f and the non-etching region 120_NE of the passivation layer 120f.

The thickness of the passivation layer 120f in the etching region 120_E of the passivation layer 120f may be greater than the thickness of the passivation layer 120f in the non-etching region 120_NE of the passivation layer 120f. For example, a vertical level of the uppermost end of the outer surface 120_E_OS of the etching region 120_E of the passivation layer 120f may be greater than a vertical level of the upper surface 120_NE_U of the non-etching region 120_NE of the passivation layer 120f. For example, the upper surface 120_NE_U of the non-etching region 120_NE of the passivation layer 120f may be in contact with the outer surface 120_E_OS of the etching region 120_E of the passivation layer 120f.

In some embodiments, the seed layer 160f may be located on the upper surface 120_E_U of the etching region 120_E of the passivation layer 120f. Unlike as shown in FIG. 11, the seed layer 160f may be located on the outer surface 120_E_OS of the etching region 120_E of the passivation layer 120f and the upper surface 120_NE_U of the non-etching region 120_NE of the passivation layer 120f.

Referring to FIG. 12, the semiconductor chip 100g may include the chip substrate 110, the wiring structure 150 (see FIG. 4), the through via 130, a passivation layer 120g, the chip pad 140, and a seed layer 160g. In the semiconductor chip 100g of FIG. 12, a thickness of the passivation layer 120g in the etching region 120_E of the passivation layer 120g is different from a thickness of the passivation layer 120 in the etching region 120_E of the passivation layer 120 of the semiconductor chip 100 of FIG. 5. A height (e.g., in vertical direction (Z direction)) of the passivation layer 120g in the etching region 120_E of the passivation layer 120g of the semiconductor chip 100g of FIG. 12 is different from a thickness of the passivation layer 120 in the etching region 120_E of the passivation layer 120 of the semiconductor chip 100 of FIG. 5.

The passivation layer 120g of the semiconductor chip 100g may include the etching region 120_E and the non-etching region 120_NE defining the etching region 120_E. The thickness of the passivation layer 120g in the etching region 120_E of the passivation layer 120g may be less than the thickness of the passivation layer 120g in the non-etching region 120_NE of the passivation layer 120g.

For example, a vertical level of the uppermost end of the outer surface 120_E_OS of the etching region 120_E of the passivation layer 120g may be lower than a vertical level of the upper surface 120_NE_U of the non-etching region 120_NE of the passivation layer 120g. For example, the upper surface 120_E_U of the etching region 120_E of the passivation layer 120g may be in contact with a side surface of the non-etching region 120_NE of the passivation layer 120g. For example, the side surface of the non-etching region 120_NE of the passivation layer 120g may define the etching region 120_E of the passivation layer 120g, and be in contact with the upper surface 120_E_U of the etching region 120_E of the passivation layer 120g.

The chip pad 140 may be located on the etching region 120_E of the passivation layer 120g. For example, a part of the side surface of the chip pad 140 may be surrounded by the passivation layer 120g. For example, a lower surface of the chip pad 140 may be located at a vertical level below a vertical level of the upper surface 120_NE_U of the non-etching region 120_NE of the passivation layer 120g. For example, the upper surface 120_NE_U of the non-etching region 120_NE of the passivation layer 120g may be in contact with the side surface of the chip pad 140.

However, embodiments of the present disclosure are not limited thereto, and the chip pad 140 may overlap with the etching region 120_E of the passivation layer 120g and the non-etching region 120_NE of the passivation layer 120g in the vertical direction, and a shape of the lower surface of the chip pad 140 may correspond to a shape of each of the etching region 120_E of the passivation layer 120g and the non-etching region 120_NE of the passivation layer 120g.

In some embodiments, the seed layer 160g may be in contact with at least a part of the lower surface of the chip pad 140 and the side surface of the chip pad 140. For example, the seed layer 160g may be located on the upper surface 120_E_U of the etching region 120_E of the passivation layer 120g and a side surface of the non-etching region 120_NE of the passivation layer 120g. The seed layer 160g may be located on the upper surface 130_U of the through via 130 and the chamfer 130_Ue of the through via 130. Unlike as shown in FIG. 12, the seed layer 160g may cover a part of the upper surface 120_E_U of the etching region 120_E of the passivation layer 120g and be spaced apart from the side surface of the non-etching region 120_NE of the passivation layer 120g.

In a process of forming the semiconductor chips 100f and 100g, heights of the passivation layers 120f and 120g may be independently adjusted for each region by partially etching the passivation layers 120f and 120g, respectively.

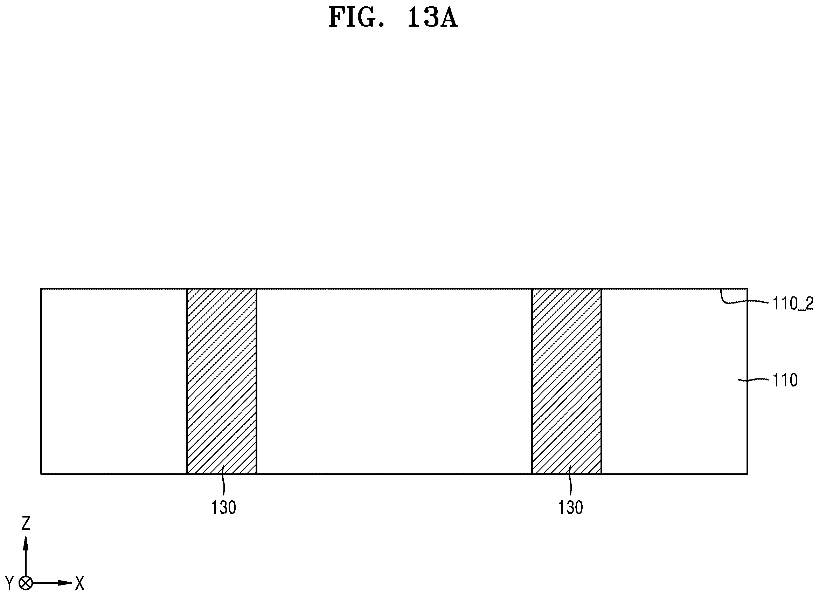

FIGS. 13A to 13K are cross-sectional views illustrating a method of manufacturing a semiconductor chip in a process order, according to embodiments.

Specifically, FIGS. 13A to 13K are cross-sectional views sequentially illustrating the method of manufacturing the semiconductor chip 100 of FIG. 5. For example, FIGS. 13A to 13K are enlarged cross-sectional views schematically illustrating the vicinity of the portion EX (see FIG. 4) of the semiconductor chip 100.

Referring to FIG. 13A together with FIG. 4, the chip substrate 110 including at least one through via 130 may be prepared. The chip substrate 110 may be attached onto a carrier substrate such that the first surface 110_1 (see FIG. 4) of the chip substrate 110 faces the carrier substrate.

A plurality of individual devices may be formed at (e.g., in or on) the chip structure 110, the wiring structure 150 (see FIG. 4) may be formed on the first surface 110_1 of the chip substrate 110, and the at least one through via 130 may penetrate the chip substrate 110. The chip substrate 110 of FIG. 13A, which is in a state before a thinning process is performed, may have a greater thickness than the chip substrate 110 in other process operations. For example, the at least one through via 130 may be formed before the thinning process is performed on the chip substrate 110.

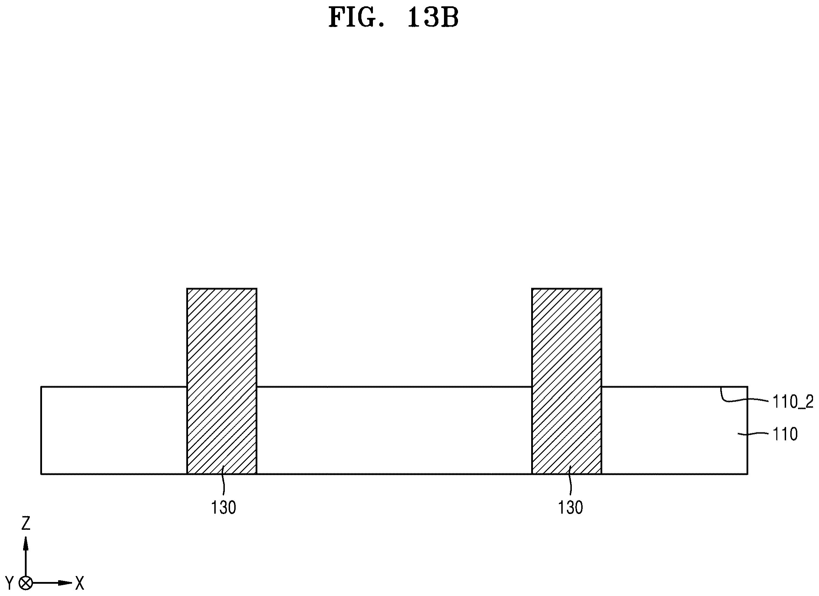

Referring to FIG. 13B, a part of the chip substrate 110 may be removed so that an upper end of the at least one through via 130 is exposed. For example, the thinning process may be performed on the chip substrate 110.

A part of the chip substrate 110 may be removed by performing a back lap process such as an etching process on the second surface 110_2 of the chip substrate 110. In this process, a part of the at least one through via 130 may protrude upward from the chip substrate 110. For example, the thickness of the chip substrate 110 may decrease while the thickness of the at least one through via 130 is maintained, and thus the at least one through via 130 may protrude upward from the chip substrate 110.

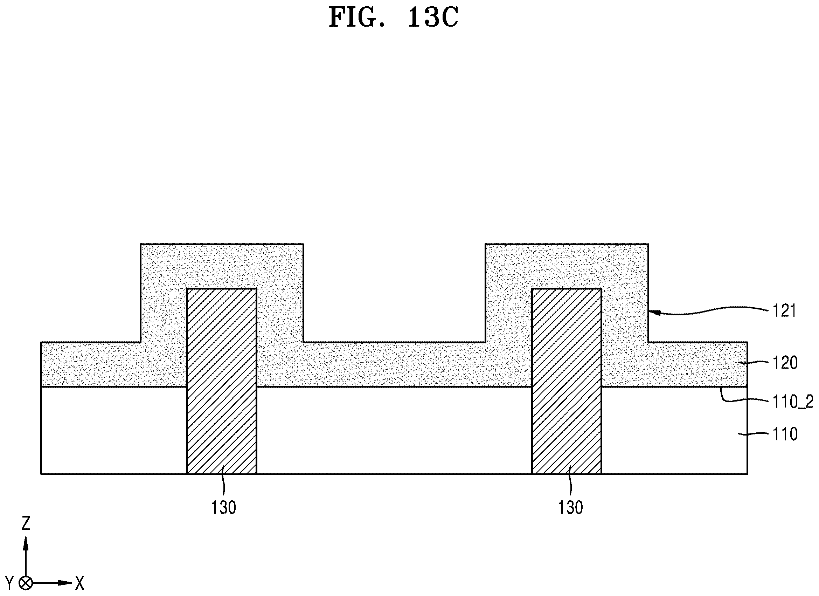

Referring to FIG. 13C, the passivation layer 120 may be applied to cover the second surface 110_2 of the chip substrate 110 and the at least one through via 130 that is protruding.

For example, the passivation layer 120 may be formed to cover the part of the at least one through via 130 that protrudes upward from the chip substrate 110. An upper portion of the at least one through via 130 may be covered by the passivation layer 120. For example, the passivation layer 120 may include at least one protrusion 121 surrounding a side surface and an upper surface of the at least one through via 130.

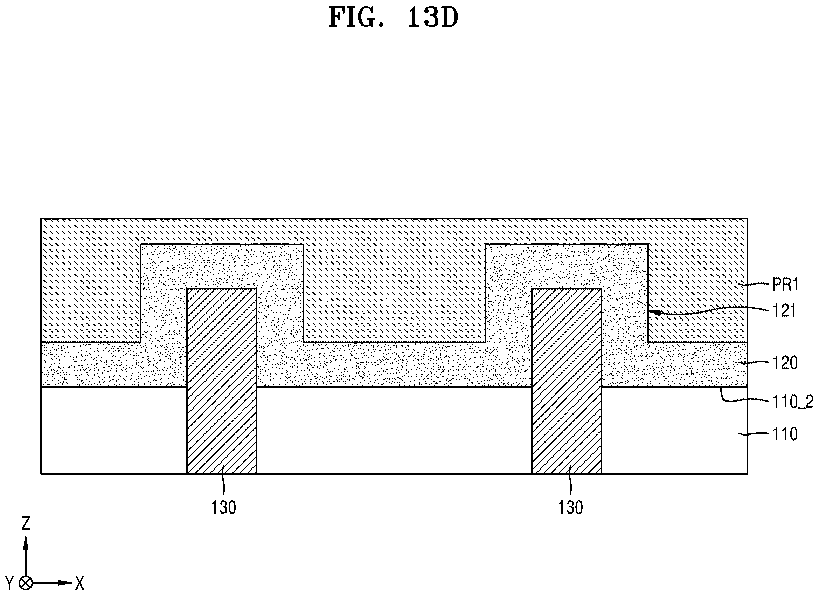

Referring to FIGS. 13D and 13E, the first mask layer PR1 may be applied and patterned.

The first mask layer PR1 may be applied to cover an upper surface of the passivation layer 120. For example, the upper surface of the first mask layer PR1 is planar in FIG. 13D, but embodiments of the present disclosure are not limited thereto, and a part of the upper surface of the first mask layer PR1 located on the upper portion of the through via 130 may have a higher vertical level than other parts of the first mask layer PR1. In some embodiments, a material of the first mask layer PR1 may include a photoresist.

Thereafter, at least one first opening Pt1 may be formed in the first mask layer PR1 so that the at least one protrusion 121 of the passivation layer 120 is exposed. The first opening Pt1 of the first mask layer PR1 may extend inward from (e.g., be recessed in) the upper surface of the first mask layer PR1, and overlap with the protrusion 121 of the passivation layer 120 in the vertical direction (e.g., Z direction).

A width of the first opening Pt1 of the first mask layer PR1 may be the same as a width of the protrusion 121 of the passivation layer 120. For example, a side surface of the first opening Pt1 of the first mask layer PR1 may be coplanar with a side surface of the protrusion 121 of the passivation layer 120. For example, an upper surface of the protrusion 121 of the passivation layer 120 may be exposed through the first opening Pt1 of the first mask layer PR1. A side surface of the protrusion 121 of the passivation layer 120 may be covered with the first mask layer PR1.

However, embodiments of the present disclosure are not limited thereto, and the width of the first opening Pt1 of the first mask layer PR1 may be greater than the width of the protrusion 121 of the passivation layer 120. For example, the side surface of the protrusion 121 of the passivation layer 120 may be exposed to the outside.

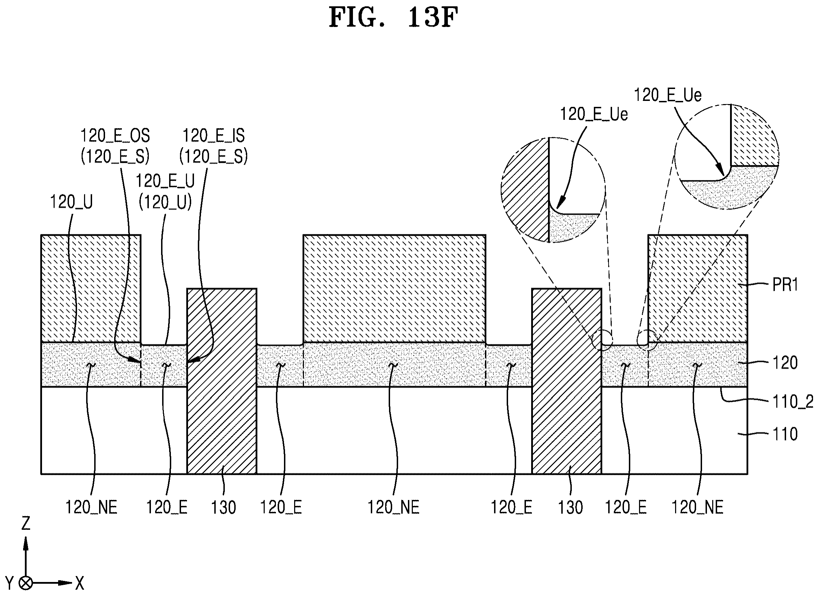

Referring to FIG. 13F, a part of the passivation layer 120 may be etched so that the upper portion of the at least one through via 130 is exposed.

A part of the passivation layer 120 exposed through the first mask layer PR1 may be removed using the first mask layer PR1 as a mask. In a process of etching a part of the passivation layer 120, a dry etching process on the passivation layer 120 may be performed. For example, argon (Ar), fluoroform (CHF₃), carbon tetrafluoride (CF₄), and oxygen (O₂) may be used in the dry etching process.

For example, a part of the passivation layer 120 exposed to the outside by the first opening Pt1 of the first mask layer PR1 may be referred to as the etching region 120_E of the passivation layer 120. For example, a part of the passivation layer 120, which is covered by the first mask layer PR1 and not etched, may be referred to as the non-etching region 120_NE of the passivation layer 120.

For example, the side surface of the first opening Pt1 of the first mask layer PR1 may be coplanar with the outer surface 120_E_OS of the etching region 120_E of the passivation layer 120. For example, the inner surface 120_E_IS of the etching region 120_E of the passivation layer 120 may be coplanar with the side surface of the through via 130.

In some embodiments, dry etching may be performed on the passivation layer 120 so that the upper surface 120_E_U of the etching region 120_E of the passivation layer 120 may be recessed. For example, the edge 120_E_Ue of the upper surface 120_E_U of the etching region 120_E of the passivation layer 120 may be curved (e.g., rounded).

In some embodiments, the upper surface 120_E_U of the etching region 120_E of the passivation layer 120 may include a first region that is planar and the edge 120_E_Ue that is curved (e.g., rounded) and surrounds the first region. For example, the edge 120_E_Ue of the upper surface 120_E_U of the etching region 120_E of the passivation layer 120 may have a curvature and be located between the first region of the etching region 120_E of the passivation layer 120 and the side surface 120_E_S of the etching region 120_E of the passivation layer 120.

For example, the uppermost end of the edge 120_E_Ue of the upper surface 120_E_U of the etching region 120_E of the passivation layer 120 may be in contact with the side surface 120_E_S of the etching region 120_E of the passivation layer 120, and the lowermost end of the edge 120_E_Ue of the upper surface 120_E of the etching region 120_E of the passivation layer 120 may be in contact with the first region of the upper surface 120_E_U of the etching region 120_E of the passivation layer 120.

In FIG. 13F, a vertical level of the uppermost end of the edge 120_E_Ue of the upper surface 120_E_U of the etching region 120_E of the passivation layer 120 is the same as a vertical level of the upper surface 120_NE_U of the non-etching region 120_NE of the passivation layer 120. However, embodiments of the present disclosure are not limited thereto, and the vertical level of the uppermost end of the edge 120_E_Ue of the etching region 120_E of the passivation layer 120 may be lower or higher than the vertical level of the upper surface 120_NE_U of the non-etching region 120_NE of the passivation layer 120.

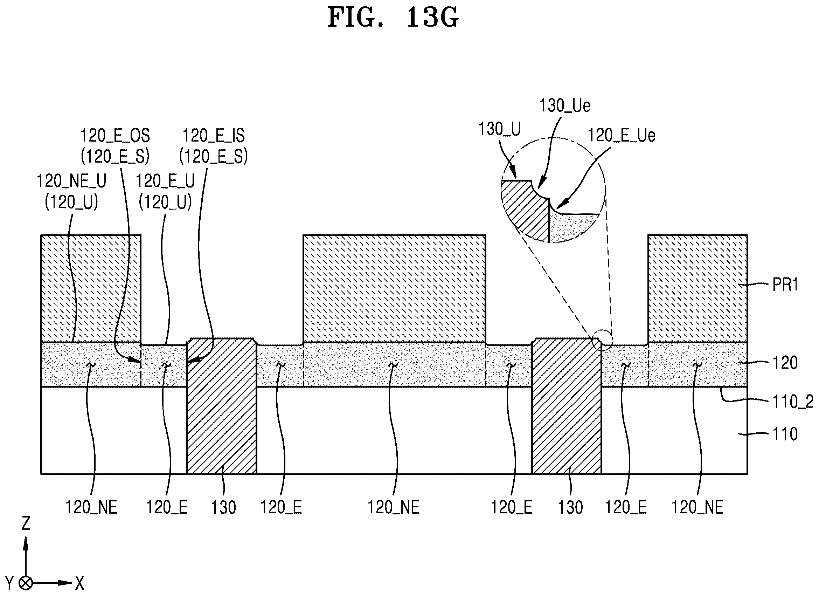

Referring to FIG. 13G, a part of the at least one through via 130 that protrudes upward from the passivation layer 120 may be etched.

A part of the at least one through via 130 protruding from the passivation layer 120 may be removed using the passivation layer 120 as a mask. For example, the etching region 120_E of the passivation layer 120 may be used as a mask. For example, a wet etching process on the at least one through via 130 may be performed in a process of etching a part of the at least one through via 130. For example, a combination of citric acid and hydrogen peroxide, a combination of ricin and hydrogen peroxide, and an Ethylenediaminetetraacetic acid (EDTA)-based solution may be used for the wet etching process.

In some embodiments, in the process of etching the through via 130, the chamfer 130_Ue may be formed in an edge of the upper surface 130_U of the through via 130. For example, the chamfer 130_Ue of the through via 130 may be a curved surface concavely recessed inward. The uppermost end of the chamfer 130_Ue may be connected to the upper surface 130_U of the through via 130, and the lowermost end of the chamfer 130_Ue may be connected to the side surface of the through via 130.

In some embodiments, as shown in FIG. 13G, the upper portion of the through via 130 may be removed such that the lowermost end of the chamfer 130_Ue of the through via 130 is in contact with the uppermost part of the upper surface 120_E_U of the etching region 120_E of the passivation layer 120. However, embodiments of the present disclosure are not limited thereto, and a vertical level of the lowermost end of the chamfer 130_Ue of the through via 130 may be higher or lower than a vertical level of the uppermost part of the upper surface of the etching region 120_E of the passivation layer 120.

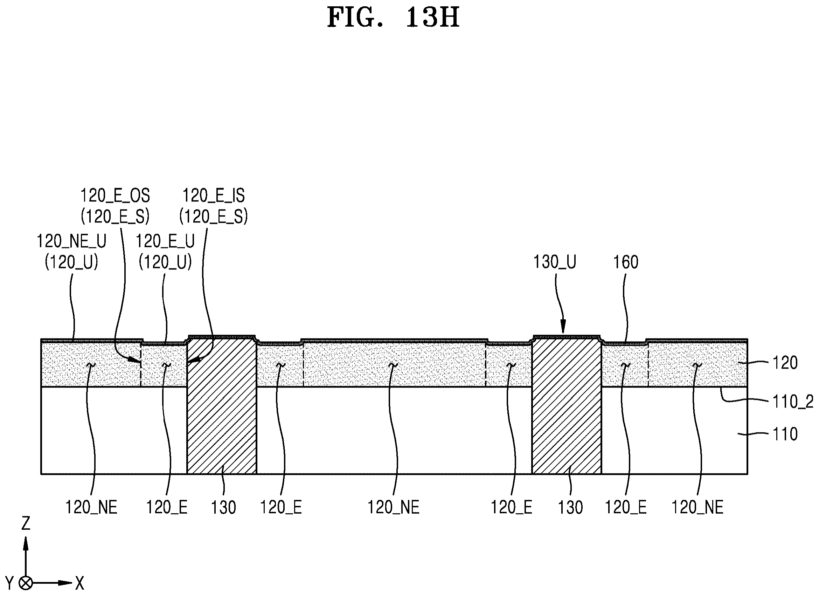

Referring to FIGS. 13H to 13K, at least one chip pad 140 may be formed on the at least one through via 130. For example, the chip pad 140 electrically connected to the through via 130 may be formed on the through via 130 and the passivation layer 120.

The upper surface 120_U of the passivation layer 120 may be exposed to the outside by removing the first mask layer PR1. Thereafter, the seed layer 160 may be conformally formed on the upper surface 120_U of the passivation layer 120, the upper surface 130_U of the through via 130, and the chamfer 130_Ue of the through via 130 as illustrated in FIG. 13H.

The seed layer 160 may have a curved shape corresponding to a shape of the upper surface 120_U of the passivation layer 120 and a shape of the chamfer 130_Ue of the through via 130.

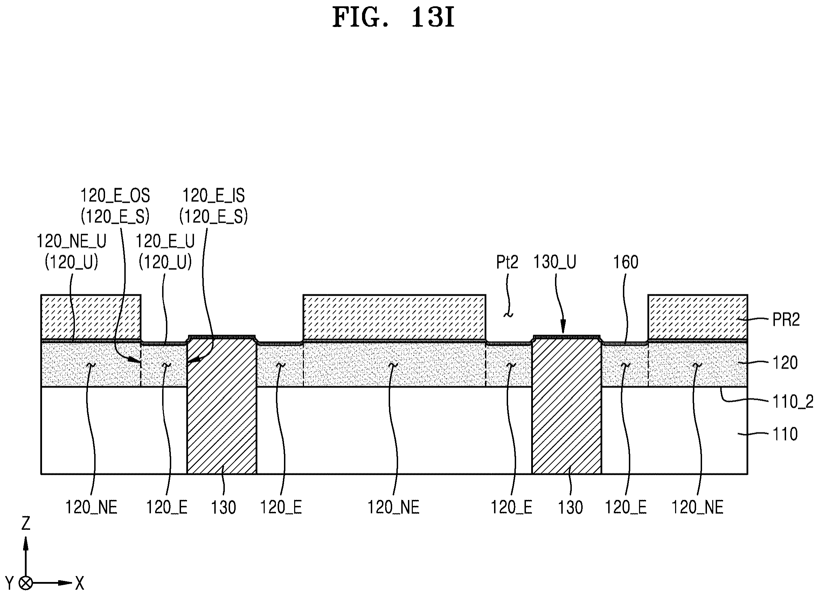

Thereafter, a second mask layer PR2 may be applied and patterned on the seed layer 160 as illustrated in FIG. 13I. For example, a material of the second mask layer PR2 may include a photoresist.

Thereafter, at least one second opening Pt2 may be formed in the second mask layer PR2 at a position in which the at least one chip pad 140 is to be formed. The through via 130 and the etching region 120_E of the passivation layer 120 may be located inside the second opening Pt2 of the second mask layer PR2.

In some embodiments, a side surface of the second opening Pt2 of the second mask layer PR2 may be coplanar with the outer surface 120_E_OS of the etching region 120_E of the passivation layer 120. However, embodiments of the present disclosure are not limited thereto, and the side surface of the second opening Pt2 of the second mask layer PR2 may be located outside the outer surface 120_E_OS of the etching region 120_E of the passivation layer 120 in at least one horizontal direction (e.g., the X direction and/or Y direction), or on the upper surface 120_E_U of the etching region 120_E of the passivation layer 120.

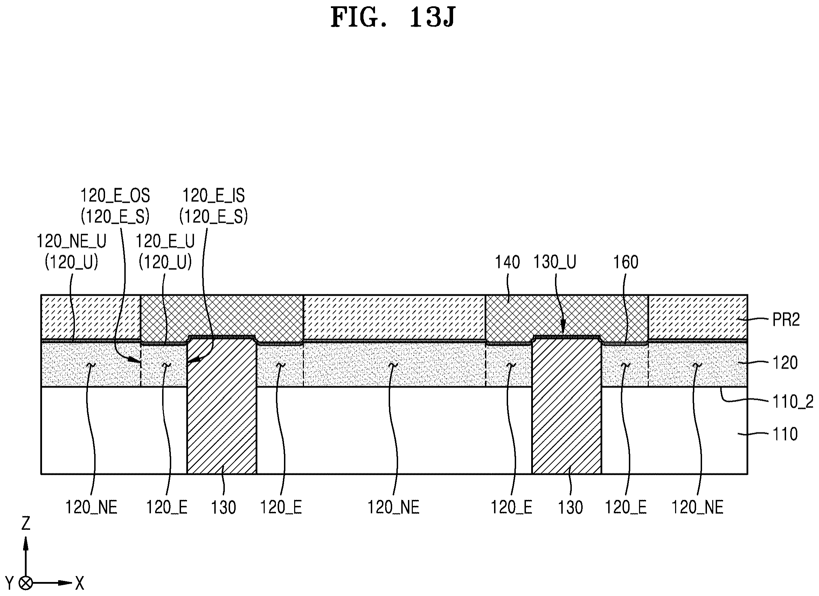

Thereafter, the chip pad 140 may be formed by filling the second opening Pt2 of the second mask layer PR2 with a metal material as illustrated in FIG. 13J. For example, the chip pad 140 may be formed by performing an electroplating process based on the seed layer 160 exposed by the second opening Pt2 of the second mask layer PR2.

In some embodiments, a width of the chip pad 140 may be the same as a width of the second opening Pt2 of the second mask layer PR2. For example, the side surface of the chip pad 140 may be aligned (e.g., coplanar) with the outer surface 120_E_OS of the etching region 120_E of the passivation layer 120 in the vertical direction (e.g., Z direction). In some embodiments, the side surface of the chip pad 140 may be located outside the outer surface 120_E_OS of the etching region 120_E of the passivation layer 120, or on the upper surface 120_E_U of the etching region 120_E of the passivation layer 120.

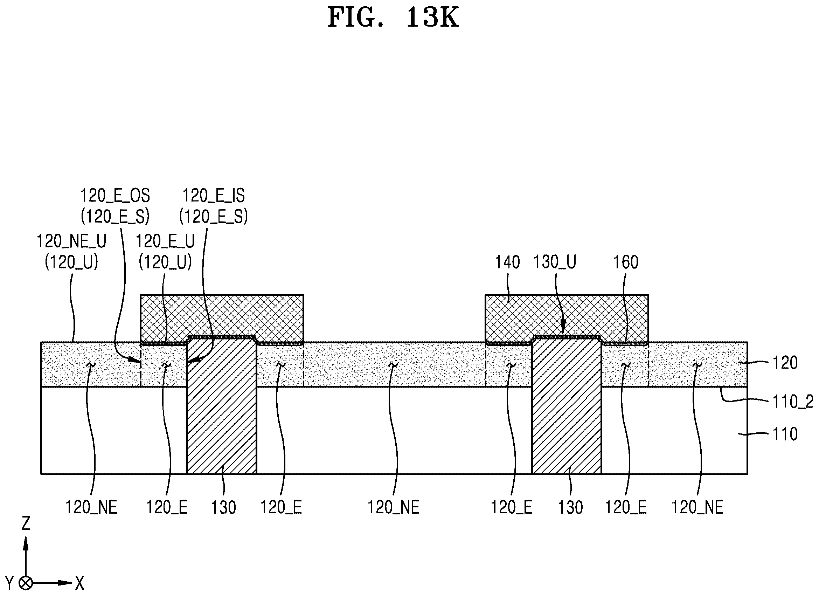

Thereafter, a part of the seed layer 160 may be exposed to the outside by removing the second mask layer PR2, and then the exposed part of the seed layer 160 may be removed as illustrated in FIG. 13K. For example, a part of the seed layer 160 located on a lower surface of the chip pad 140 may remain, and a part of the seed layer 160 exposed to the outside may be removed. The seed layer 160 may be located on the lower surface of the chip pad 140. The seed layer 160 may be located between the chip pad 140 and the through via 130 and between the chip pad 140 and the passivation layer 120.

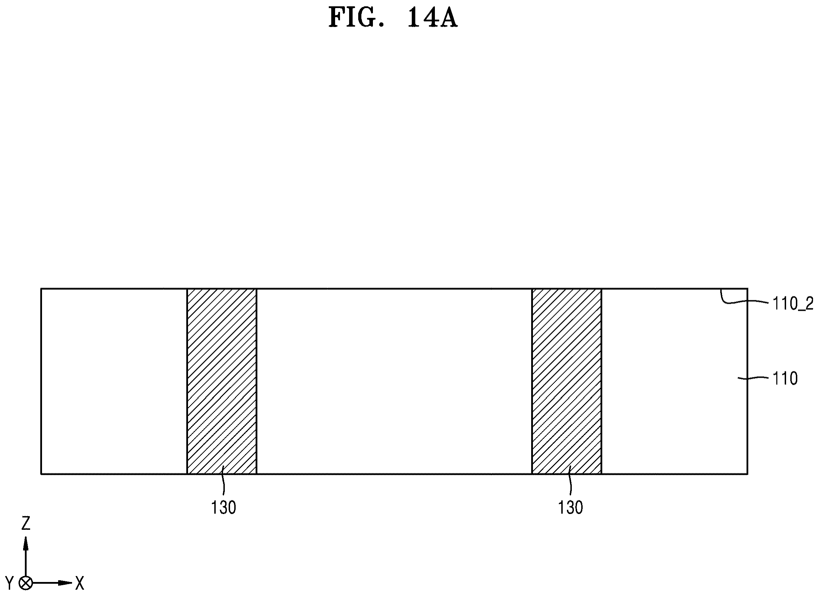

FIGS. 14A to 14O are cross-sectional views illustrating a method of manufacturing a semiconductor chip in a process order, according to embodiments.

Specifically, FIGS. 14A to 14Oare cross-sectional views sequentially illustrating the method of manufacturing the semiconductor chip 100a of FIG. 6. For example, FIGS. 14A to 14O are enlarged cross-sectional views schematically illustrating the vicinity of the portion EX (see FIG. 4) of the semiconductor chip 100a.

Referring to FIG. 14A together with FIG. 4, the chip substrate 110 including at least one the through via 130 may be prepared. The chip substrate 110 may be attached onto a carrier substrate such that the first surface 110_1 of the chip substrate 110 faces the carrier substrate.

A plurality of individual devices may be formed at (e.g., in or on) the chip structure 110, the wiring structure 150 (see FIG. 4) may be formed on the first surface 110_1 of the chip substrate 110, and the at least one through via 130 may penetrate the chip substrate 110. The chip substrate 110 of FIG. 14A is in a state before a thinning process is performed, and the at least one through via 130 may be formed before the thinning process is performed on the chip substrate 110.

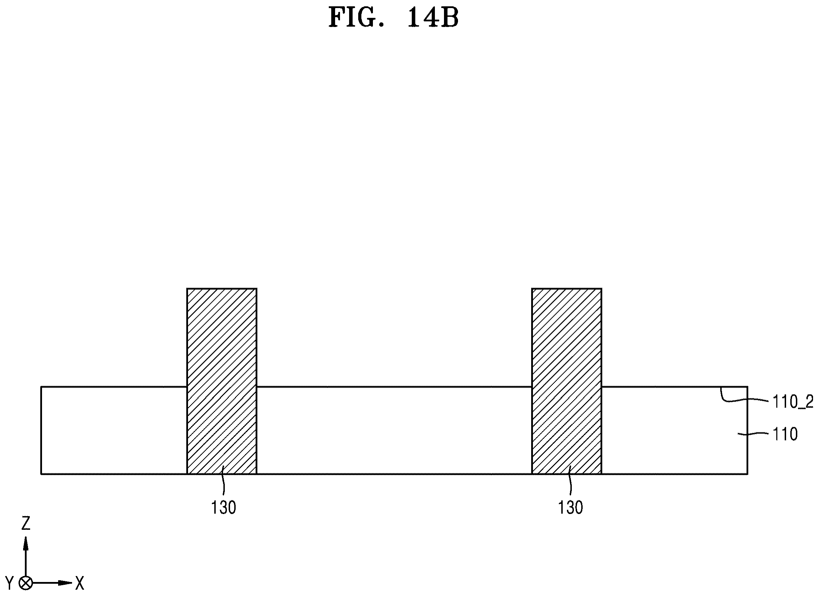

Referring to FIG. 14B, a part of the chip substrate 110 may be removed so that an upper end of the at least one through via 130 is exposed. For example, the thinning process may be performed on the chip substrate 110.

The chip substrate 110 may be thinned by performing a backlap process on the second surface 110_2 of the chip substrate 110. A part of the at least one through via 130 may protrude upward from the second surface 110_2 of the chip substrate 110.

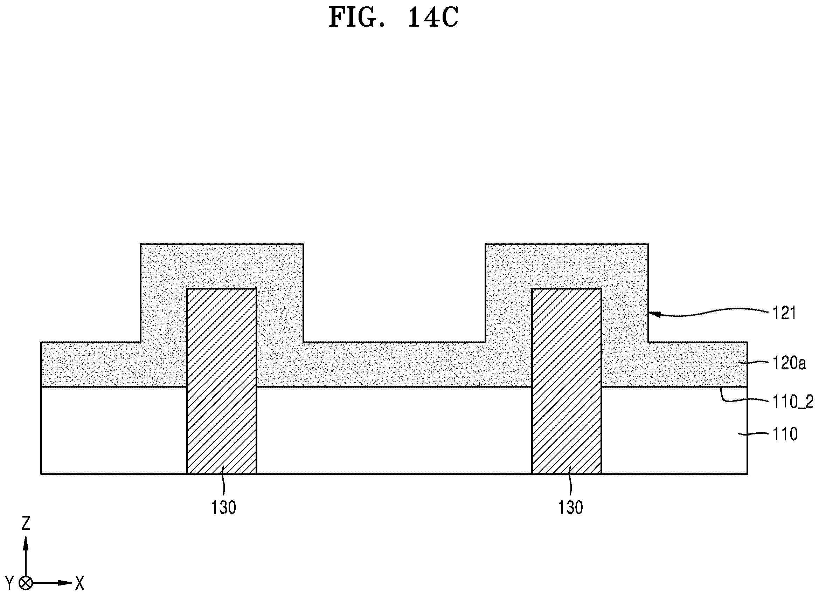

Referring to FIG. 14C, the passivation layer 120a may be applied to cover the second surface 110_2 of the chip substrate 110 and the at least one through via 130 that is protruding.

For example, the passivation layer 120a may be formed to cover a part of the at least one through via 130 that protrudes upward from the chip substrate 110. An upper portion of the at least one through via 130 may be covered by the passivation layer 120a. For example, the passivation layer 120a may include at least one protrusion 121 surrounding a side surface and an upper surface of the at least one through via 130 that is protruding.

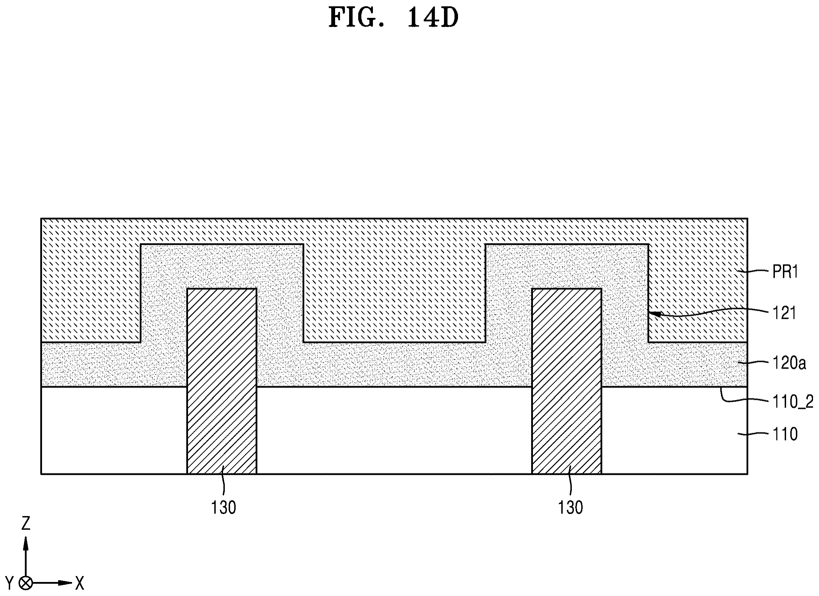

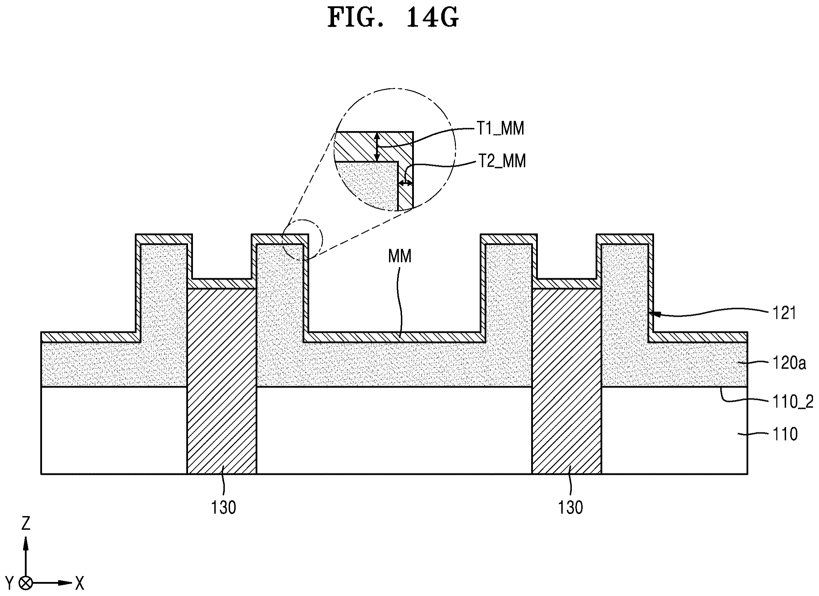

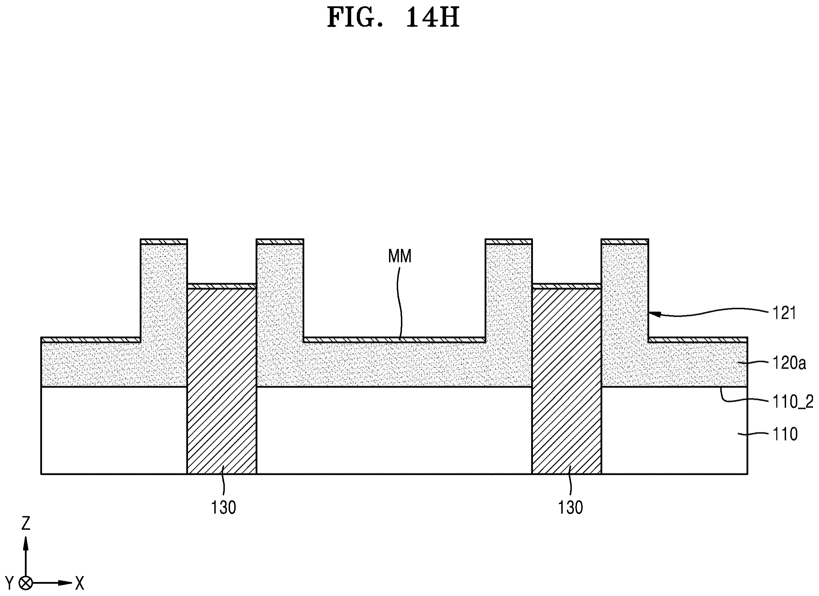

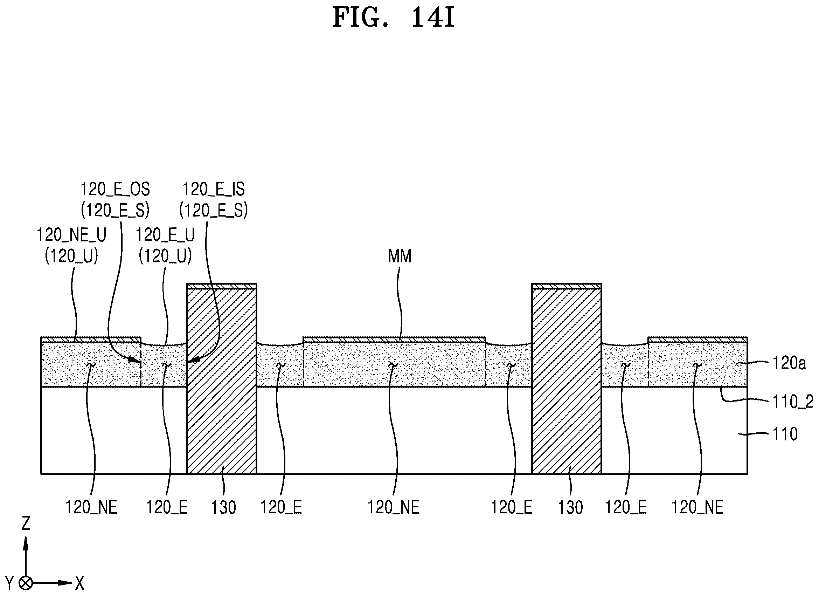

FIGS. 14D to 14I show a process of removing a part of the passivation layer 120a. Specifically, FIGS. 14D to 14F show a first etching process, FIGS. 14G and 14H show an operation of forming a third mask layer, and FIG. 14I shows a second etching process.

Referring to FIG. 14D, the first mask layer PR1 may be applied to cover an upper surface of the passivation layer 120a. In some embodiments, a material of the first mask layer PR1 may include a photoresist.

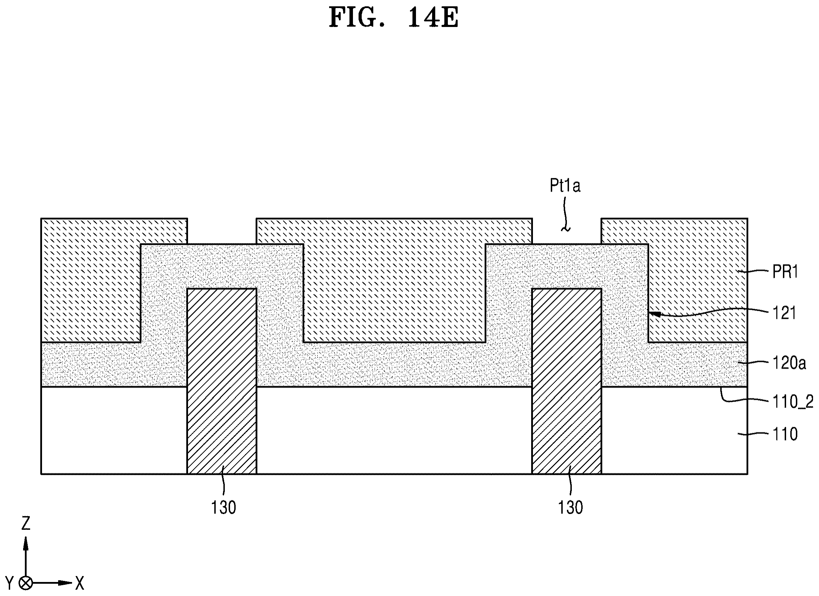

Referring to FIG. 14E, at least one first opening Pt1a may be formed in the first mask layer PR1 so that at least a part of an upper surface of the at least one protrusion 121 of the passivation layer 120a is exposed. A width of the first opening Pt1a of the first mask layer PR1 may be less than a width of the protrusion 121 of the passivation layer 120a. For example, a side surface of the first opening Pt1a of the first mask layer PR1 (e.g., a side surface of the first mask layer PR1 defining the first opening Pt1a) may be located on an upper surface of the protrusion 121 of the passivation layer 120a.

For example, the first opening Pt1a of the first mask layer PR1 and the through via 130 may overlap with each other in the vertical direction (e.g., Z direction). For example, the width of the first opening Pt1a of the first mask layer PR1 may be the same as the width of the through via 130. The side surface of the first opening Pt1a of the first mask layer PR1 may be aligned (e.g., coplanar) with a side surface of the through via 130 in the vertical direction (Z direction).

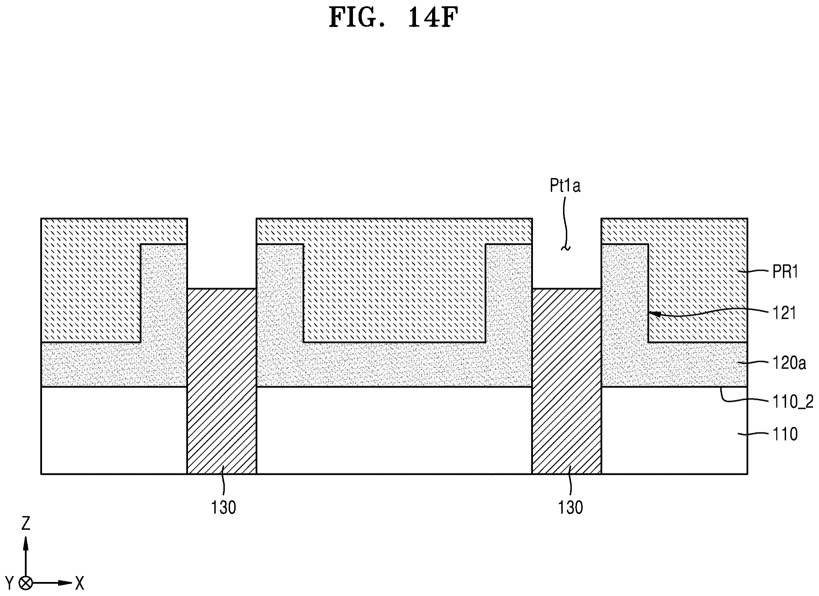

Referring to FIG. 14F, a part of the at least one protrusion 121 of the passivation layer 120a may be etched so that the upper surface of the at least one through via 130 is exposed. For example, an etching process performed in FIG. 14F may be referred to as the first etching process.

A part of the passivation layer 120a exposed to the first mask layer PR1 may be removed using the first mask layer PR1 as a mask. In a process of etching the part of the passivation layer 120a, a dry etching process on the passivation layer 120a may be performed. For example, argon (Ar), fluoroform (CHF₃), carbon tetrafluoride (CF₄), and oxygen (O₂) may be used in the dry etching process.

For example, the upper surface of the at least one through via 130 may be exposed by removing the part of the at least one protrusion 121 of the passivation layer 120a exposed to the outside by the at least one first opening Pt1a of the first mask layer PR1. After the first etching process is performed, a part of the protrusion 121 of the passivation layer 120a covering the side surface of the through via 130 may remain, and the side surface of the through via 130 may not be exposed to the outside.

Referring to FIG. 14G, a third mask layer MM may be applied to an upper surface of a resultant product of FIG. 14F.

During a deposition process, a deposition speed of the third mask layer MM in the vertical direction (e.g., Z direction) and a deposition speed in a horizontal direction may be different from each other. Accordingly, a thickness of the third mask layer MM in the vertical direction (e.g., Z direction) may be different from a thickness of the third mask layer MM in the horizontal direction.

A deposition speed of a part of the third mask layer MM deposited in the horizontal direction may be slower than that of a part of the third mask layer MM deposited in the vertical direction (e.g., Z direction). Accordingly, the part of the third mask layer MM deposited in the vertical direction (e.g., Z direction) may have a first thickness T1_MM, and the part of the third mask layer MM deposited in the horizontal direction (e.g., X direction) may have a second thickness T2_MM that is thinner than the first thickness T1_MM.

For example, the part of the third mask layer MM formed on the side surface of the protrusion 121 of the passivation layer 120a may have the second thickness T2_MM, and the part formed on the upper surface 120_U of the passivation layer 120a may have the first thickness T1_MM.

In some embodiments, the third mask layer MM may be formed through at least one from among a chemical vapor deposition (CVD) process, an atomic layer deposition (ALD) process, and a physical vapor deposition (PVD) process. In some embodiments, the third mask layer MM may include a metallic material such as titanium (Ti).

Referring to FIG. 14H, a part of the third mask layer MM may be etched so that the side surface of the at least one protrusion 121 of the passivation layer 120a is exposed.

The part of the third mask layer MM formed on the at least one protrusion 121 of the passivation layer 120a may be thinner than the other parts of the third mask layer MM, and thus even though the part is removed, the third mask layer MM may remain on the upper surface 120_U of the passivation layer 120a.

For example, the thickness of the part of the third mask layer MM deposited in the vertical direction (e.g., Z direction) may be greater than the thickness of the part of the third mask layer MM deposited in the horizontal direction, and thus even though the part deposited in the horizontal direction of the third mask layer MM is completely removed, the thickness of the part deposited in the vertical direction (e.g., Z direction) may partially remain.

Accordingly, only a part of the third mask layer MM may be etched to expose the side surface of the passivation layer 120a to the outside and cover the upper surface of the at least one protrusion 121 of the passivation layer 120a.

Referring to FIG. 14I, a part of the passivation layer 120a may be etched so that the side surface of the at least one through via 130 is exposed. For example, an etching process performed in FIG. 14I may be referred to as the second etching process.

In the second etching process, wet etching may be performed on the passivation layer 120a by using the third mask layer MM as a mask. For example, in the second etching process, a hydrofluoric acid (HF) substrate solution may be used.

For example, in the second etching process, a part of the passivation layer 120a may be removed so that the side surface of the at least one through via 130 is exposed from the side surface of the protrusion 121 of the passivation layer 120a. For example, a part of the upper surface 120_U of the passivation layer 120a, which is covered by the third mask layer MM, may be protected during the etching process.

A part of the passivation layer 120a protected by the third mask layer MM may not be etched and thus may be referred to as the non-etching region 120_NE of the passivation layer 120a. The second etching process may be performed on a part of the passivation layer 120a where the at least one protrusion 121 is located, and thus the part may be referred to as the etching region 120_E of the passivation layer 120a.

The upper surface 120_E_U of the etching region 120_E of the passivation layer 120a may be curved. For example, in the second etching process, an isotropic etching process may be performed on the passivation layer 120a, so that the upper surface 120_E_U of the etching region 120_E of the passivation layer 120a may be an inwardly concave curved surface.

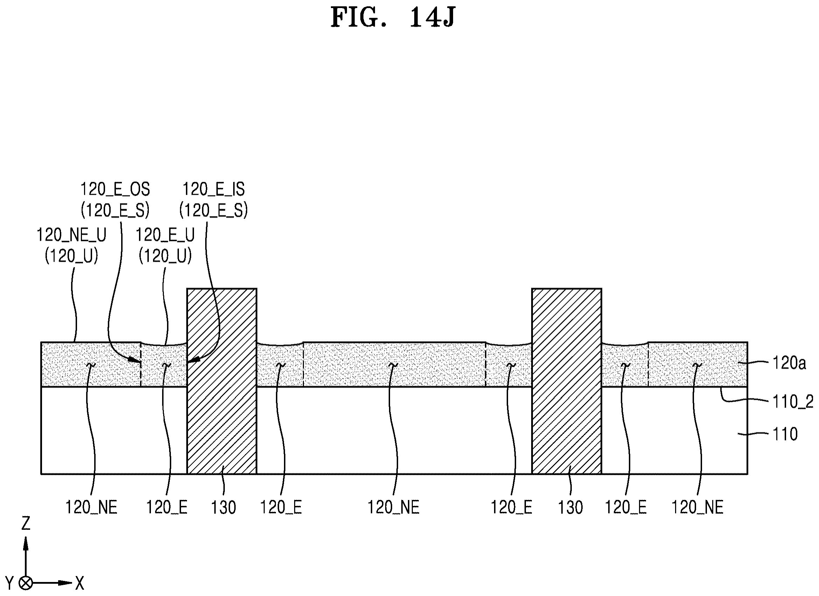

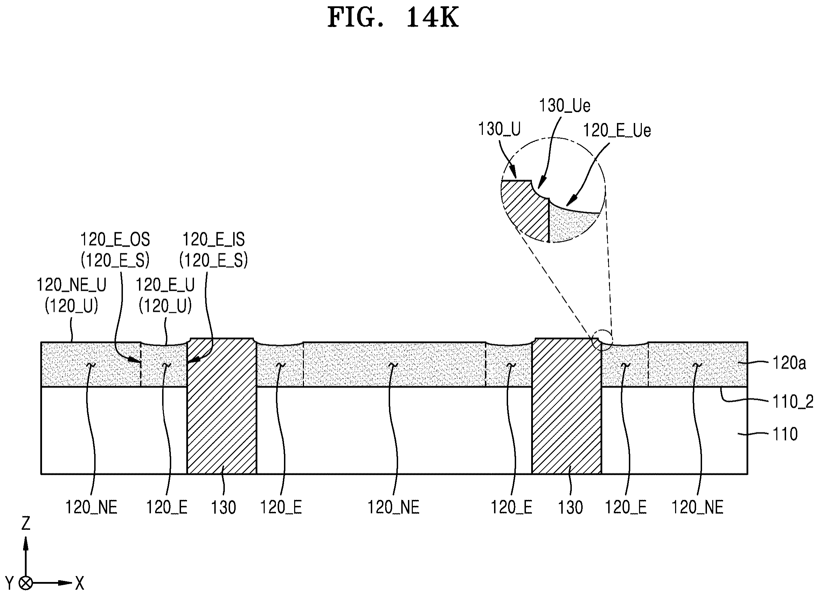

Referring to FIGS. 14J and 14K, the third mask layer MM may be removed, and the part of the at least one through via 130 protruding upward from the passivation layer 120a may be etched.

The third mask layer MM may be removed so that the upper surface 120_NE_U of the non-etching region 120_NE of the passivation layer 120a and the upper surface of the at least one through via 130 are exposed. Thereafter, the part of the at least one through via 130 protruding from the passivation layer 120a may be removed using the passivation layer 120a as a mask.

For example, a wet etching process on the at least one through via 130 may be performed in a process of etching the part of the at least one through via 130. For example, a combination of citric acid and hydrogen peroxide, a combination of ricin and hydrogen peroxide, and an EDTA-based solution may be used in the wet etching process.

In some embodiments, in the process of etching the at least one through via 130, the chamfer 130_Ue may be formed in an edge of the upper surface 130_U of the through via 130 as illustrated in FIG. 14K. For example, the chamfer 130_Ue of the through via 130 may be a curved surface concavely recessed inward. The uppermost end of the chamfer 130_Ue may be connected to the upper surface 130_U of the through via 130, and the lowermost end of the chamfer 130_Ue may be connected to the side surface of the through via 130.

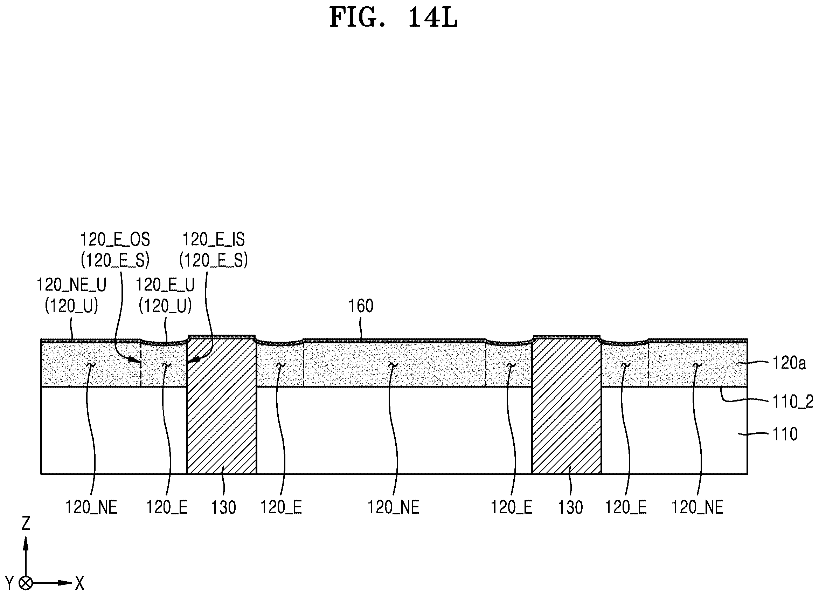

Referring to FIGS. 14L to 14O, at least one chip pad 140 may be formed on the at least one through via 130. For example, the chip pad 140 electrically connected to the through via 130 may be formed on the through via 130 and the passivation layer 120a.

The seed layer 160 may be conformally formed on the upper surface 120_U of the passivation layer 120a, the upper surface 130_U of the at least one through via 130, and the chamfer 130_Ue of the at least one through via 130 as illustrated in FIG. 14L. The seed layer 160 may have a curved shape corresponding to a shape of the upper surface 120_U of the passivation layer 120a and a shape of the chamfer 130_Ue of the at least one through via 130.

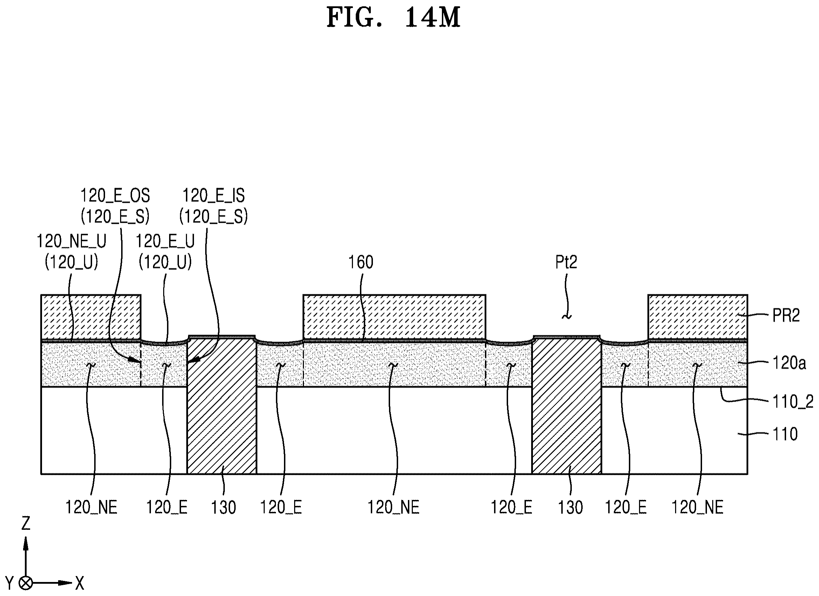

Thereafter, the second mask layer PR2 may be applied and patterned on the seed layer 160. For example, a material of the second mask layer PR2 may include a photoresist. Thereafter, the at least one second opening Pt2 may be formed in the second mask layer PR2 at a position in which the at least one chip pad 140 is to be formed as illustrated in FIG. 14M. The through via 130 and the etching region 120_E of the passivation layer 120a may be located inside the second opening Pt2 of the second mask layer PR2.

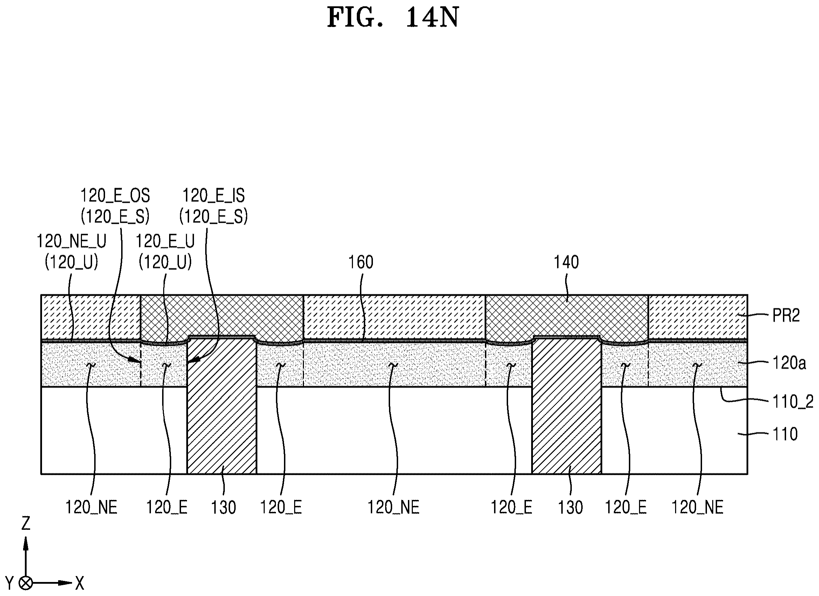

Thereafter, the chip pad 140 may be formed by filling the second opening Pt2 of the second mask layer PR2 with a metal material as illustrated in FIG. 14N. For example, the chip pad 140 may be formed by performing an electroplating process based on the seed layer 160 exposed by the second opening Pt2 of the second mask layer PR2.

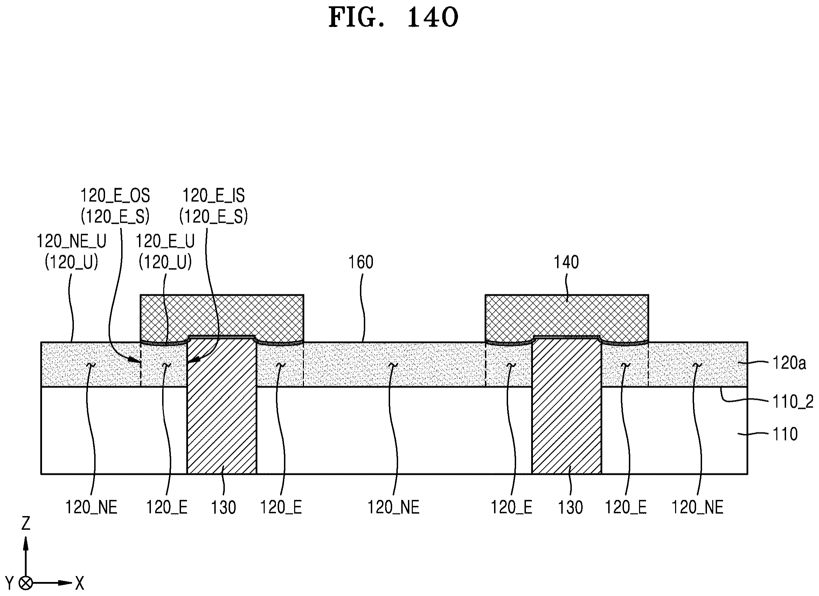

Thereafter, a part of the seed layer 160 may be exposed to the outside by removing the second mask layer PR2, and then the exposed part of the seed layer 160 may be removed as illustrated in FIG. 14O. For example, a part of the seed layer 160 located on a lower surface of the chip pad 140 may remain, and a part of the seed layer 160 exposed to the outside may be removed. The seed layer 160 may be located on the lower surface of the chip pad 140. The seed layer 160 may be located between the chip pad 140 and the through via 130 and between the chip pad 140 and the passivation layer 120a.

In some embodiments, an operation of forming the chip pad 140 described above with reference to FIGS. 14I to 14O may be substantially the same as an operation of forming the chip pad 140 described above with reference to FIGS. 13H to 13K.

According to some embodiments of the present disclosure, a method of manufacturing a semiconductor chip may include: removing a part of a chip substrate so that a through via, in the chip substrate, protrudes upward from the chip substrate; forming a passivation layer on the through via and an upper surface of the chip substrate; etching a part of the passivation layer so that the through via protrudes upward from the passivation layer; etching a part of the through via protruding upward from the passivation layer; and forming a chip pad on the through via.

In some embodiments, the etching of the part of the passivation layer may include performing dry etching on the passivation layer.

In some embodiments, the etching of the part of the passivation layer may include a first etching operation of removing a part of the passivation layer so that an upper surface of the through via is exposed, and a second etching operation of removing a part of the passivation layer so that a side surface of the through via is exposed.

In some embodiments, in the first etching operation, dry etching may be performed on the passivation layer, and in the second etching operation, wet etching may be performed on the passivation layer.

In some embodiments, the etching of the part of the passivation layer may further include forming a mask layer between the first etching operation and the second etching operation, and the forming of the mask layer may include applying the mask layer and etching the mask layer.

In some embodiments, the applying of the mask layer may include forming the mask layer so that a thickness of a first portion of the mask layer extending in a horizontal direction is greater than a thickness of a second portion of the mask layer extending in a vertical direction.

In some embodiments, the etching of the mask layer may include removing a part of the mask layer so that a side wall of the passivation layer is exposed.

In some embodiments, the removing of the part of the through via may include performing wet etching on the through via.

In some embodiments, the removing of the part of the through via may include removing the part of the through via so that a vertical level of an upper surface of the through via is higher than a vertical level of an upper surface of the passivation layer.

In some embodiments, the forming of the chip pad may include forming a seed layer conformally on the upper surface of the passivation layer and the upper surface of the through via.

While non-limiting example embodiments have been particularly shown and described with reference to the accompanying drawings, it will be understood that various changes in form and details may be made therein without departing from the scope of the present disclosure.

## Claims

1. A semiconductor chip (100) comprising:
a chip substrate (110) comprising a first surface (110_1) and a second surface (110_2) opposite to the first surface (110_1);
a passivation layer (120) on the second surface (110_2) of the chip substrate (110);
a through via (130) penetrating the chip substrate (110) and the passivation layer (120);
a chip pad (140) on the through via (130) and the passivation layer (120); and
a seed layer (160) between the through via (130) and the chip pad (140) and between the passivation layer (120) and the chip pad (140),
wherein the passivation layer (120) comprises an etching region (120_E) in which the through via (130) is located, and
wherein an upper surface (120_E_U) of the etching region (120_E) of the passivation layer (120) is recessed.

2. The semiconductor chip (100) of claim 1, further comprising a wiring structure (150) on the first surface (110_1) of the chip substrate (110), the wiring structure (150) comprising a wiring pattern (151) and a wiring insulating layer (152) at least partially surrounding the wiring pattern (151).

3. The semiconductor chip (100) of claim 1 or 2, wherein an edge (120_E_Ue) of the upper surface (120_N_U) of the etching region (120_E) of the passivation layer (120) is curved.

4. The semiconductor chip (100) of claim 3, wherein
the upper surface (120_E_U) of the etching region (120_E) of the passivation layer (120) is flat, and comprises a first region having a vertical level that is lower than an uppermost end of a side surface (120_E_S) of the etching region (120_E), and
the edge (120_E_Ue) of the upper surface (120_E_U) of the etching region (120_E) of the passivation layer (120) extends from the first region to the uppermost end of the side surface (120_E_S) of the etching region (120_E).

5. The semiconductor chip (100a) of any of claims 1 to 3, wherein the upper surface (120_E_U) of the etching region (120_E) of the passivation layer (120a) comprises a concave curved surface.

6. The semiconductor chip (100a) of claim 5, wherein the upper surface (120_E_U) of the etching region (120_E) of the passivation layer (120a) comprises a curved surface that comes closer toward a lower surface of the etching region (120_E) in a direction away from a side surface (120_E_S) of the etching region (120_E).

7. The semiconductor chip (100f, 100g) of any preceding claim, wherein
the passivation layer (120f, 120g) further comprises a non-etching region (120_NE) defining the etching region (120_E), and
a thickness of the etching region (120_E) of the passivation layer (120f, 120g) is different from a thickness of the non-etching region (120_NE) of the passivation layer (120f, 120g).

8. The semiconductor chip (100g) of claim 7, wherein the thickness of the etching region (120_E) of the passivation layer (120g) is less than the thickness of the non-etching region (120_NE) of the passivation layer (120g).

9. The semiconductor chip (100) of any of claims 1 to 6, wherein
the passivation layer (120) further comprises a non-etching region (120_NE) defining the etching region (120_E),
an outer surface (120_E_OS) of the etching region (120_E) of the passivation layer (120) is in contact with the non-etching region (120_NE) of the passivation layer (120), and
the outer surface (120_E_OS) of the etching region (120_E) of the passivation layer (120) is coplanar with a side surface of the chip pad (140) in a vertical direction of the semiconductor chip (100).

10. The semiconductor chip (100d) of any of claims 1 to 6, wherein
the passivation layer (120d) further comprises a non-etching region (120_NE) defining the etching region (120_E),
an outer surface (120_E_OS) of the etching region (120_E) of the passivation layer (120d) is a boundary surface between the etching region (120_E) of the passivation layer (120d) and the non-etching region (120_NE) of the passivation layer (120), and
in a plan view, the outer surface (120_E_OS) of the etching region (120_E) of the passivation layer (120d) is located outside a side surface of the chip pad (140) in a horizontal direction of the semiconductor chip (100d).

11. The semiconductor chip (100e) of any of claims 1 to 6, wherein
the passivation layer (120e) further comprises a non-etching region (120_NE) defining the etching region (120_E),
an outer surface (120_E_OS) of the etching region (120_E) of the passivation layer (120e) is a boundary surface between the etching region (120_E) of the passivation layer (120e) and the non-etching region (120_NE) of the passivation layer (120e), and
in a plan view, a side surface of the chip pad (140) is located outside the etching region (120_E) of the passivation layer (120e) in a horizontal direction of the semiconductor chip (100e).

12. The semiconductor chip (100e) of claim 11, wherein
the chip pad (140) overlaps with the etching region (120_E) of the passivation layer (120e) and the non-etching region (120_NE) of the passivation layer (120e) in a vertical direction of the semiconductor chip (100), and
the seed layer (160e) is on an upper surface (120_NE_U) of the non-etching region (120_NE) of the passivation layer (120e).

13. A semiconductor chip (100) comprising:
a chip substrate (110) comprising a first surface (110_1) and a second surface (110_2) opposite to the first surface (110_1);
a wiring structure (150) on the first surface of the chip substrate (110), the wiring structure (150) comprising a wiring pattern (151) and a wiring insulating layer (152) at least partially surrounding the wiring pattern (151);
a passivation layer (120) on the second surface (110_2) of the chip substrate (110);
a through via (130) penetrating the chip substrate (110) and the passivation layer (120);
a chip pad (140) on the through via (130) and the passivation layer (120); and
a seed layer (160) between the through via (130) and the chip pad (140) and between the passivation layer (120) and the chip pad (140),
wherein the through via (130) comprises a chamfer (130_Ue) extending along an edge of an upper surface (130_U) of the through via (130).

14. The semiconductor chip (100) of claim 13, wherein the chamfer (130_Ue) is formed so that a horizontal width of the through via (130) decreases toward the upper surface (130_U) of the through via (130).

15. The semiconductor chip (100) of claim 13 or 14, wherein the chamfer (130_Ue) of the through via (130) comprises a curved surface.
